# EUROPEAN PATENT APPLICATION

(11) **EP 4 709 068 A1**
(43) Date of publication of application: **11.03.2026**
(21) Application number: 24818349.3
(22) Date of filing: 30.03.2024
(51) Int. Cl.: H05K 7/20

(54) **POWER SUPPLY MODULE AND ENERGY STORAGE SYSTEM**

(30) Priority: 07.06.2023 CN 202310673189
(71) Applicant: Huawei Digital Power Technologies Co., Ltd., Shenzhen, Guangdong 518043 (CN)
(72) Inventor: ZHU, Fangqi, Shenzhen, Guangdong 518043 (CN); LI, Jiyang, Shenzhen, Guangdong 518043 (CN); MENG, Hao, Shenzhen, Guangdong 518043 (CN)
(74) Representative: Maiwald GmbH
(86) International application number: PCT/CN2024/085093
(87) International publication number: WO 2024/250812

(57) **Abstract**

This application provides a power module and an energy storage system. The power module includes a housing, a connector, an inductor, a cold plate, and an air-liquid heat exchanger. The connector, the air-liquid heat exchanger, the cold plate, and the inductor are sequentially arranged inside the housing along a first direction. The housing includes a front plate and a rear plate. The front plate and the rear plate are oppositely arranged along the first direction. The connector is arranged between the air-liquid heat exchanger and the front plate along the first direction. The connector includes a cold plate inlet, a heat exchanger inlet, a cold plate outlet, and a heat exchanger outlet. Along a second direction, the cold plate inlet and the cold plate outlet are adjacently arranged, and the heat exchanger inlet and the heat exchanger outlet are adjacently arranged. Along a third direction, the heat exchanger inlet and one of the cold plate inlet and the cold plate outlet are adjacently arranged, and the heat exchanger outlet and the other one of the cold plate inlet and the cold plate outlet are adjacently arranged. The third direction, the second direction, and the first direction are perpendicular to each other. The power module in this application has a small size, and has good heat dissipation effect for various heat-generating components, and can reduce heat dissipation costs.

## Description

This application claims priority to Chinese Patent Application No. 202310673189.X, filed with the China National Intellectual Property Administration on June 7, 2023 and entitled "POWER MODULE AND ENERGY STORAGE SYSTEM", which is incorporated herein by reference in its entirety.

### TECHNICAL FIELD

This application relates to the field of power conversion technologies, and in particular, to a power module and an energy storage system.

### BACKGROUND

With rapid development of the new energy industry, output power of a power conversion apparatus gradually increases. Therefore, there is also a higher requirement for a heat dissipation capability of the power conversion apparatus. Various components are disposed in the power conversion apparatus, and different components have different heat-generating situations. An existing heat dissipation system cannot meet heat dissipation requirements of the various components at the same time. Alternatively, when the heat dissipation system can meet the heat dissipation requirements of the various components, energy consumption and costs of the heat dissipation system are high, and a volume of the heat dissipation system is large, which makes it difficult to miniaturize the power conversion apparatus.

### SUMMARY

This application provides a power module and an energy storage system.

According to a first aspect, an embodiment of this application provides a power module. The power module includes a housing, a connector, an inductor, a cold plate, and an air-liquid heat exchanger. The connector, the air-liquid heat exchanger, the cold plate, and the inductor are sequentially arranged inside the housing along a first direction. The housing includes a front plate and a rear plate. The front plate and the rear plate are oppositely arranged along the first direction. The connector is arranged between the air-liquid heat exchanger and the front plate along the first direction. The connector includes a cold plate inlet, a heat exchanger inlet, a cold plate outlet, and a heat exchanger outlet. Along a second direction, the cold plate inlet and the cold plate outlet are adjacently arranged, and the heat exchanger inlet and the heat exchanger outlet are adjacently arranged. The second direction is perpendicular to the first direction. Along a third direction, the heat exchanger inlet and one of the cold plate inlet and the cold plate outlet are adjacently arranged, and the heat exchanger outlet and the other one of the cold plate inlet and the cold plate outlet are adjacently arranged. The third direction is perpendicular to the second direction and the first direction.

In the power module provided in this application, on one hand, the cold plate in the power module is configured to dissipate heat for a high-heat-generating component, so that a heat dissipation requirement of the high-heat-generating component can be met, and good heat dissipation effect can be achieved for the high-heat-generating component. The air-liquid heat exchanger in the power module is configured to dissipate heat for medium- and low-heat-generating components. The power module in this application uses a composite heat dissipation manner in which the cold plate and the air-liquid heat exchanger are combined, so that heat dissipation requirements of various heat-generating components are met, good heat dissipation effect can be achieved for the power module, heat dissipation costs of the power module can be reduced, and a total volume of the cold plate and the air-liquid heat exchanger can be reduced. In addition, a heat dissipation system including the cold plate and the air-liquid heat exchanger has a simple structure and few parts, and is easy to install in the housing.

On another hand, the cold plate and the air-liquid heat exchanger are connected to a same connector, and receive a heat exchange medium and discharge the heat exchange medium by using the same connector. The cold plate and the air-liquid heat exchanger are both connected to the connector, so that a quantity of connectors is reduced, and heat dissipation pipeline arrangement in the power module is more orderly.

On still another hand, the connector, the air-liquid heat exchanger, the cold plate, and the inductor are sequentially arranged inside the housing along the first direction. In this arrangement manner, internal space of the housing can be fully used, to facilitate reduction in a volume of the power module. A proper layout of components in the housing is conducive to improving reliability of the power module.

In a possible implementation, the housing includes a first side plate and a second side plate. The first side plate and the second side plate are oppositely arranged along the second direction. The connector, the air-liquid heat exchanger, the cold plate, and the inductor are arranged between the first side plate and the second side plate. Along the second direction, a distance between the connector and the first side plate is less than a distance between the connector and the second side plate, the distance between the connector and the first side plate is less than a distance between the air-liquid heat exchanger and the first side plate, the distance between the connector and the second side plate is greater than a distance between the air-liquid heat exchanger and the second side plate, and at least one of a spacing between the cold plate inlet and the cold plate outlet or a spacing between the heat exchanger inlet and the heat exchanger outlet is less than the spacing between the air-liquid heat exchanger and the first side plate.

First, the connector is disposed closer to the first side plate, to facilitate installation and use of the power module in an energy storage cabinet. Second, the spacing between the heat exchanger inlet and the heat exchanger outlet is small, and the heat exchanger inlet and the heat exchanger outlet are tightly arranged. The spacing between the cold plate inlet and the cold plate outlet is small, and the cold plate inlet and the cold plate outlet are tightly arranged, to facilitate reduction in a size of the connector along the second direction. In addition, the connector is located in a corner between the first side plate and the front plate, which improves utilization of internal space of the housing and reduces impact on arrangement of other components and wires.

In a possible implementation, the connector includes a first sub-cavity and a second sub-cavity. The first sub-cavity and the second sub-cavity are adjacently arranged and spaced apart along the second direction. The first sub-cavity is configured to communicate with the cold plate inlet and the heat exchanger inlet. The second sub-cavity is configured to communicate with the cold plate outlet and the heat exchanger outlet.

The first sub-cavity and the second sub-cavity are provided, so that the cold plate and the air-liquid heat exchanger run in parallel. This improves heat dissipation efficiency of the power module. The cold plate inlet and the heat exchanger inlet receive the heat exchange medium through the first sub-cavity, and the cold plate outlet and the heat exchanger outlet discharge the heat exchange medium through the second sub-cavity. This reduces quantities of joints and pipes through which the connector is connected to the outside, and can also reduce a volume of the connector, to facilitate miniaturization of the power module.

In a possible implementation, the connector includes a connection base, a first cover, and a partition plate. The connection base includes a first groove. The cold plate inlet, the cold plate outlet, the heat exchanger inlet, and the heat exchanger outlet each penetrate a groove bottom of the first groove along the first direction. The partition plate is located in the first groove and is configured to divide the first groove along the second direction. An outer peripheral surface of the first cover is fastened to a groove wall of the first groove, and a surface that is of the first cover and that faces the groove bottom of the first groove is fastened to the partition plate. The groove bottom of the first groove and the first cover are spaced apart along the first direction. The connection base and the first cover enclose to form a first cavity, and the partition plate divides the first cavity to form the first sub-cavity and the second sub-cavity.

In a possible implementation, the connector includes a first sub-cavity, a second sub-cavity, and a third sub-cavity. The first sub-cavity and the third sub-cavity are adjacently arranged and spaced apart along the third direction. The first sub-cavity or the third sub-cavity and the second sub-cavity are adjacently arranged and spaced apart along the second direction. The first sub-cavity is configured to communicate with the heat exchanger inlet. The second sub-cavity is configured to communicate with the heat exchanger outlet and the cold plate inlet. The third sub-cavity is configured to communicate with the cold plate outlet.

The first sub-cavity, the second sub-cavity, and the third sub-cavity are provided, so that the cold plate and the air-liquid heat exchanger run in series. This can reduce heat dissipation energy consumption of the power module. The first sub-cavity and the third sub-cavity are respectively configured to receive and discharge the heat exchange medium, and the second sub-cavity is configured to implement a connection between the cold plate and the air-liquid heat exchanger. This reduces the quantities of joints and pipes through which the connector is connected to the outside, and can also reduce the volume of the connector, to facilitate miniaturization of the power module.

In addition, because the cold plate is mainly configured to dissipate heat for the high-heat-generating component, and the air-liquid heat exchanger is mainly configured to dissipate heat for the medium- and low-heat-generating components, a difference between temperatures existing before and after the heat exchange medium flows through the cold plate is large, and a difference between temperatures existing before and after the heat exchange medium flows through the air-liquid heat exchanger is small. In this application, the heat exchange medium is controlled to sequentially flow through the air-liquid heat exchanger and the cold plate, so that heat dissipation for the heat-generating component in two heat dissipation manners can be considered, which is conducive to better heat dissipation for the various heat-generating components.

In a possible implementation, the connector further includes a second cavity and a liquid discharge hole. The second cavity and the first sub-cavity or the second sub-cavity are adjacently arranged and spaced apart along the first direction. The liquid discharge hole communicates with the second cavity. The second cavity is provided on a side that is of the connection base and that faces away from the first cavity. If leakage occurs on the connector, the leaked heat exchange medium is collected in the second cavity, and is discharged out of the second cavity through the liquid discharge hole. The second cavity is provided to seal the connector for a second time, to reduce a risk that the leaked liquid causes damage to the component in the housing. The heat exchange medium discharged from the liquid discharge hole may be discharged out of the housing through a pipeline.

In a possible implementation, the connector includes the first cover, the connection base, a second cover, and the partition plate. The first cover and the second cover are arranged on two sides of the connection base along the first direction, and respectively enclose with the two sides of the connection base to form the first cavity and the second cavity. The partition plate is located in the first cavity and is configured to divide the first cavity to form the first sub-cavity and the second sub-cavity. The connection base includes the cold plate inlet, the cold plate outlet, the heat exchanger inlet, and the heat exchanger outlet. The cold plate inlet, the cold plate outlet, the heat exchanger inlet, and the heat exchanger outlet penetrate the connection base along the first direction. The first cover includes a liquid inlet hole and a liquid outlet hole. The liquid inlet hole and the liquid outlet hole each penetrate the first cover along the first direction. The liquid inlet hole is configured to communicate with at least one of the cold plate inlet or the heat exchanger inlet. The liquid outlet hole is configured to communicate with at least one of the cold plate outlet or the heat exchanger outlet. The second cover includes a first opening, a second opening, a third opening, and a fourth opening. The first opening, the second opening, the third opening, and the fourth opening each penetrate the second cover along the first direction. The first opening, the second opening, the third opening, and the fourth opening are respectively arranged opposite to the cold plate inlet, the cold plate outlet, the heat exchanger inlet, and the heat exchanger outlet along the first direction.

The power module further includes a liquid inlet pipe of the cold plate, a liquid outlet pipe of the cold plate, a liquid inlet pipe of the heat exchanger, and a liquid outlet pipe of the heat exchanger. One end of the liquid inlet pipe of the cold plate, one end of the liquid outlet pipe of the cold plate, one end of the liquid inlet pipe of the heat exchanger, and one end of the liquid outlet pipe of the heat exchanger respectively communicate with the cold plate inlet, the heat exchanger inlet, the cold plate outlet, and the heat exchanger outlet. The other end of the liquid inlet pipe of the cold plate extends into the second cavity through the first opening and is fastened to an inner wall of the cold plate inlet. The other end of the liquid outlet pipe of the cold plate extends into the second cavity through the second opening and is fastened to an inner wall of the cold plate outlet. The other end of the liquid inlet pipe of the heat exchanger extends into the second cavity through the third opening and is fastened to an inner wall of the heat exchanger inlet. The other end of the liquid outlet pipe of the heat exchanger extends into the second cavity through the fourth opening and is fastened to an inner wall of the heat exchanger outlet.

Along the first direction, the first opening and the cold plate inlet are oppositely arranged. A distance between the first opening and the cold plate inlet is short. When the liquid inlet pipe of the cold plate is connected to the cold plate inlet, a pipeline is short and does not need to be bent. This reduces costs, reduces a risk of bending and breaking the liquid inlet pipe of the cold plate, and also improves reliability of a connection between the liquid inlet pipe of the cold plate and the cold plate inlet. Similarly, along the first direction, the second opening and the cold plate outlet are oppositely arranged, the third opening and the heat exchanger inlet are oppositely arranged, and the fourth opening and the heat exchanger outlet are oppositely arranged. This can also reduce costs and improve reliability of connections between the connection base and the liquid outlet pipe of the cold plate, the liquid inlet pipe of the heat exchanger, and the liquid outlet pipe of the heat exchanger.

In a possible implementation, the power module includes a liquid inlet joint and a liquid outlet joint. The liquid inlet joint and the liquid outlet joint are fastened to the first cover and are respectively connected to the liquid inlet hole and the liquid outlet hole. The front plate includes a through hole. The through hole penetrates the front plate along the first direction. Along the first direction, a projection of the through hole covers a projection of the liquid inlet joint and a projection of the liquid outlet joint, and a projection of the first cover covers the projection of the through hole. Along the third direction, lengths of the liquid inlet joint and the liquid outlet joint are greater than a distance between the first cover and the front plate.

Along the first direction, the liquid inlet joint and the liquid outlet joint extend from the inside of the housing to the outside of the housing through the through hole. The power module may be connected to an external cooling assembly outside the housing. On one hand, operation space outside the housing is larger, which facilitates connections of two liquid cooling pipes of the cooling assembly to the liquid inlet joint and the liquid outlet joint. On another hand, a connection point between the power module and the liquid cooling pipe is provided outside the housing. If the heat exchange medium leaks due to a loose connection between the joint and the pipe during long-term running of the power module, the leaked heat exchange medium is located outside the housing, to avoid damage to the component in the housing.

In addition, along the first direction, the projection of the first cover covers the projection of the through hole, and an area of the first cover is greater than an area of the through hole. The area of the through hole is small, so that sealing performance of the housing is ensured.

In a possible implementation, when the cold plate and the air-liquid heat exchanger are connected in parallel, the liquid inlet joint and the liquid outlet joint are adjacently arranged and spaced apart along the second direction. When the cold plate and the air-liquid heat exchanger are connected in series, the liquid inlet joint and the liquid outlet joint are adjacently arranged and spaced apart along the third direction.

In a possible implementation, the power module further includes a circuit board and a plurality of power transistors. The housing includes a top plate and a bottom plate. The top plate and the bottom plate are oppositely arranged along the third direction. The circuit board is arranged between and spaced from the top plate and the bottom plate. The plurality of power transistors and the cold plate are arranged on a side that is of the circuit board and that faces the bottom plate. The cold plate is in contact with at least one power transistor along the first direction.

In the power module provided in this application, the power transistor is a high heat-generating component, and the cold plate is configured to dissipate heat for the power transistor, so that cooling efficiency of the power transistor can be improved. The first direction is a direction parallel to the circuit board, and the cold plate is bonded to the power transistor along the first direction, so that a size of the power module along the third direction can be reduced.

In a possible implementation, the power module includes a plurality of connected cold plates. The plurality of cold plates are spaced apart along the first direction. The plurality of power transistors include a plurality of columns of power transistors that are spaced apart along the first direction. Each column of power transistors includes a plurality of power transistors sequentially arranged along the second direction. The plurality of power transistors of each column of power transistors are in contact with a same cold plate.

In the power module provided in this application, one cold plate may be configured to cool at least one column of power transistors, which improves utilization of the cold plate. In addition, in this application, the plurality of cold plates are disposed to cool the plurality of columns of power transistors, so that heat dissipation can be better performed on the plurality of columns of power transistors in the power module, to improve reliability of the power module.

In a possible implementation, at least one cold plate is arranged between two adjacent columns of power transistors. The at least one cold plate includes two sides along the first direction. One side of the at least one cold plate is in contact with a plurality of power transistors of one column of power transistors. The other side of the at least one cold plate is in contact with a plurality of power transistors of the other column of power transistors. Both sides of the cold plate along the first direction are used to cool the power transistors. One cold plate may cool two columns of power transistors, which improves utilization of the cold plate.

In a possible implementation, along the third direction, a distance between the air-liquid heat exchanger and the top plate is greater than a distance between the cold plate and the top plate, a spacing between the top plate and at least one of the cold plate inlet or the cold plate outlet is less than the spacing between the air-liquid heat exchanger and the top plate, and a spacing between the bottom plate and at least one of the heat exchanger inlet or the heat exchanger outlet is less than a spacing between the cold plate and the bottom plate. The air-liquid heat exchanger and the cold plate are disposed in a staggered manner along the third direction, and the cold plate inlet, the cold plate outlet, the heat exchanger inlet, and the heat exchanger outlet are provided in a centralized manner, to facilitate reduction in the size of the connector.

In a possible implementation, the air-liquid heat exchanger includes a plurality of connected heat exchange plates. When the air-liquid heat exchanger is located between the connector and the circuit board along the first direction, and the air-liquid heat exchanger is arranged between and spaced from the top plate and the bottom plate along the third direction, the plurality of heat exchange plates are spaced apart along the first direction.

Along the third direction, a projection of the air-liquid heat exchanger does not overlap the projection of the circuit board. The air-liquid heat exchanger and the circuit board are disposed in a staggered manner, so that the air-liquid heat exchanger does not interfere with carrying of the component on the circuit board, and space utilization of the circuit board is high, which is conducive to improving performance of the power module.

Usually, to carry more onboard components, the circuit board has a large volume. In addition, because the inductor is located on a side that is of the circuit board and that is close to the rear plate along the first direction X, a distance between the air-liquid heat exchanger and the front plate is small, and usually, no component is placed between the air-liquid heat exchanger and the front plate. In this case, the plurality of heat exchange plates of the air-liquid heat exchanger are spaced apart along the first direction, and the air-liquid heat exchanger performs ventilation along the third direction. Air in the housing passes through a gap between two adjacent heat exchange plates along the third direction, and performs heat exchange with the heat exchange plates, to cool the air in the housing. The plurality of heat exchange plates are arranged along the first direction, which is more conducive to heat dissipation for the power module.

In a possible implementation, the air-liquid heat exchanger includes a plurality of connected heat exchange plates. When a projection of the air-liquid heat exchanger along the third direction overlaps a projection of the circuit board along the third direction, and the projection of the air-liquid heat exchanger along the third direction is staggered with a projection of the cold plate along the third direction, the plurality of heat exchange plates are spaced apart along the third direction.

The air-liquid heat exchanger and the circuit board are disposed in an overlapping manner along the third direction, and both front and rear sides of the air-liquid heat exchanger along the first direction are disposed with the onboard components. In this case, the plurality of heat exchange plates are arranged along the third direction, and the air-liquid heat exchanger performs ventilation along the first direction, so that heat dissipation for both the front and rear onboard components on the circuit board along the first direction can be considered.

In a possible implementation, the power module includes a plurality of inductors and a plurality of fans. The plurality of inductors are spaced apart along the second direction. The plurality of fans are spaced apart along the second direction. The fan is located between the inductor and the circuit board along the first direction. The fan plays a role in disturbing flow, and the fan may provide power for the air to flow to the air-liquid heat exchanger, to improve heat dissipation effect of the air-liquid heat exchanger. The fan is located between the inductor and the circuit board, which does not interfere with installation of the various components, and can also achieve good heat dissipation effect.

In a possible implementation, the power module further includes a first baffle plate, a second baffle plate, and a third baffle plate. The first baffle plate and the second baffle plate are located on two sides that are of the circuit board and that are along the second direction. The third baffle plate is located between the top plate and the fan along the third direction. Two sides of the first baffle plate along the second direction are connected to the circuit board and the first side plate. Two sides of the second baffle plate along the second direction are connected to the circuit board and the second side plate. When two sides of the third baffle plate along the first direction are connected to the circuit board and the inductor, the air-liquid heat exchanger is located between the connector and the circuit board along the first direction or a projection of the air-liquid heat exchanger along the third direction overlaps a projection of the circuit board along the third direction.

The first baffle plate, the second baffle plate, and the third baffle plate are disposed to guide the air to circulate through parts below and above the circuit board. The third baffle plate is configured to cover a gap between the inductor and the circuit board, to prevent a case in which the air is blocked by the inductor when flowing in a gap between the circuit board and the bottom plate along the first direction and then does not pass through the inductor, which causes poor heat dissipation effect of the inductor. After the third baffle plate is disposed, the third baffle plate blocks the air from flowing from the gap between the inductor and the circuit board to the top plate, which is conducive to improving heat dissipation effect of the inductor.

The first baffle plate and the second baffle plate are respectively configured to cover a gap between the circuit board and the first side plate and a gap between the circuit board and the second side plate, to prevent a case in which the air flowing in a gap between the circuit board and the top plate along the first direction directly flows to the gap between the circuit board and the bottom plate through the gap between the circuit board and the first side plate and the gap between the circuit board and the second side plate, which causes poor heat dissipation effect of a heat-generating component at a front end. In this application, the first baffle plate and the second baffle plate are disposed, and the air flowing in the part above the circuit board needs to flow to the part below the circuit board through a gap between the circuit board and the front plate. The air flows within a range inside the entire housing, which is more conducive to implementing heat dissipation for the various heat-generating components by the air-liquid heat exchanger.

In a possible implementation, the power module further includes a first baffle plate, a second baffle plate, and a third baffle plate. The first baffle plate and the second baffle plate are located on two sides that are of the circuit board and that are along the second direction. The third baffle plate is located between the top plate and the fan along the third direction. Two sides of the first baffle plate along the second direction are connected to the circuit board and the first side plate. Two sides of the second baffle plate along the second direction are connected to the circuit board and the second side plate. When two sides of the third baffle plate along the first direction are connected to the circuit board and the rear plate, a projection of the air-liquid heat exchanger along the third direction overlaps a projection of the circuit board along the third direction.

When the projection of the air-liquid heat exchanger along the third direction overlaps the projection of the circuit board along the third direction, the first baffle plate, the second baffle plate, and the third baffle plate are disposed to guide the air to flow from the front plate to the rear plate along the first direction in the gap between the circuit board and the bottom plate, and then flow from the rear plate to the front plate in the gap between the circuit board and the first side plate and the gap between the circuit board and the second side plate along the first direction.

The third baffle plate is configured to cover a gap between the rear plate and the circuit board. The third baffle plate restricts the air to flowing in the part below the circuit board. In this case, the air first passes through the inductor and flows to the rear plate along the first direction, and then flows to the first side plate and the second side plate, which is conducive to improving heat dissipation effect of the inductor and ensuring heat dissipation effect of other heat-generating components.

The first baffle plate and the second baffle plate are respectively configured to cover the gap between the circuit board and the first side plate and the gap between the circuit board and the second side plate, and restrict the air to flowing in the part below the circuit board and circulating through the two sides that are of the circuit board and that are along the second direction, which is conducive to implementing heat dissipation for the various heat-generating components by the air-liquid heat exchanger. In this heat dissipation mode, the air mainly flows along the first direction. In this case, a ventilation direction of the air-liquid heat exchanger is set to the first direction, that is, the plurality of heat exchange plates are spaced apart along the third direction, which is conducive to achieving good heat dissipation effect by the air-liquid heat exchanger.

According to a second aspect, an embodiment of this application provides an energy storage system. The energy storage system includes an energy storage cabinet, a battery pack, and the foregoing power module. The battery pack is connected to the power module and supplies power to a load by using the power module. The energy storage cabinet includes a cabinet body, a cabinet door, and a cooling assembly. The cabinet door is configured to close the cabinet body. The power module and the battery pack are stacked inside the cabinet body. The cooling assembly is connected to the cold plate inlet, the heat exchanger inlet, the cold plate outlet, and the heat exchanger outlet of the connector through two liquid cooling pipes.

### BRIEF DESCRIPTION OF DRAWINGS

FIG. 1 is a diagram of an energy storage system according to an implementation of this application;
FIG. 2 is a diagram of an energy storage cabinet according to an implementation of this application;
FIG. 3 is a three-dimensional diagram of a power module according to an implementation of this application;
FIG. 4 is a diagram of a power module according to an implementation of this application;
FIG. 5 is an exploded view of a connector according to an implementation of this application;
FIG. 6 is an exploded view of a connector according to an implementation of this application;
FIG. 7 is a diagram of a first cover according to an implementation of this application;
FIG. 8 is an exploded view of a connector according to an implementation of this application;
FIG. 9 is an exploded view of a connector according to an implementation of this application;
FIG. 10 is a three-dimensional diagram of a circuit board, a cold plate, and an air-liquid heat exchanger according to an implementation of this application;
FIG. 11 is a front view of a circuit board, a cold plate, and an air-liquid heat exchanger according to an implementation of this application;
FIG. 12 is a rear view of a circuit board, a cold plate, and an air-liquid heat exchanger according to an implementation of this application;
FIG. 13 is a top view of a circuit board, a cold plate, and an air-liquid heat exchanger according to an implementation of this application;
FIG. 14 is a diagram of a power module according to an implementation of this application;
FIG. 15 is a diagram of a power module according to an implementation of this application;
FIG. 16 is a front view of a circuit board, a cold plate, and an air-liquid heat exchanger according to an implementation of this application;
FIG. 17 is a top view of a circuit board, a cold plate, and an air-liquid heat exchanger according to an implementation of this application;
FIG. 18 is a diagram of a power module according to an implementation of this application;
FIG. 19 is a diagram of a power module according to an implementation of this application; and
FIG. 20 is a diagram of a power module according to an implementation of this application.

### DESCRIPTION OF EMBODIMENTS

The following describes the technical solutions in embodiments of this application with reference to accompanying drawings in embodiments of this application. It is clearly that the described embodiments are merely some rather than all of embodiments of this application.

The terms "first", "second", and the like in this specification are merely intended for a purpose of description, and shall not be understood as an indication or implication of relative importance or implicit indication of a quantity of indicated technical features. Therefore, a feature limited by "first" or "second" may explicitly or implicitly include one or more features. In description of this application, unless otherwise stated, "a plurality of' means two or more than two.

In addition, in this specification, position terms such as "top" and "bottom" are defined relative to positions of structures in the accompanying drawings. It should be understood that these position terms are relative concepts used for relative description and clarification, and may correspondingly change according to changes in the positions of the structures.

For ease of understanding, the following first explains and describes English abbreviations and related technical terms used in embodiments of this application.

DC: direct current, namely, direct current. DC-DC indicates that a direct current is converted into a direct current, that is, a direct current is input and a direct current is output.

AC: alternating current, namely, alternating current. AC-DC indicates that an alternating current is converted into a direct current. DC-AC indicates that a direct current is converted into an alternating current. AC-AC indicates that an alternating current is converted into an alternating current.

IGBT: The IGBT is an abbreviation for insulated gate bipolar transistor, and means the insulated gate bipolar transistor.

MOSFET: The MOSFET is an abbreviation for metal-oxide-semiconductor field-effect transistor, means the metal-oxide-semiconductor field-effect transistor, and is also referred to as a MOS transistor.

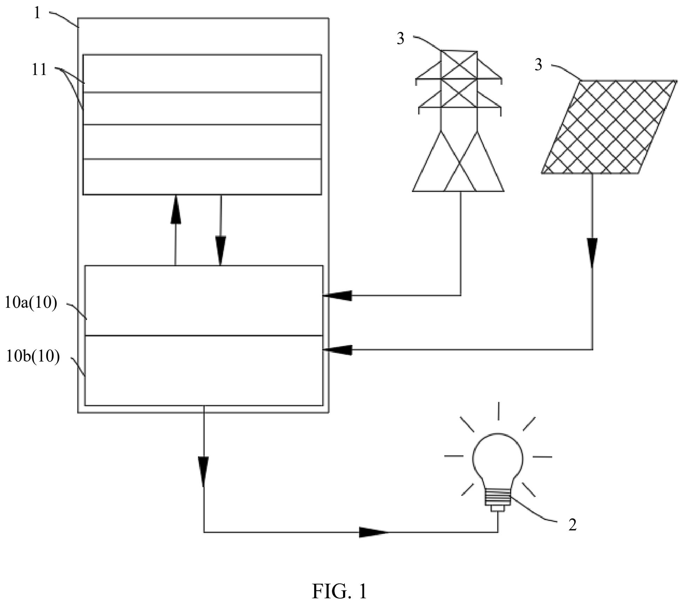

FIG. 1 is a diagram of an energy storage system according to an implementation of this application. The energy storage system includes an energy storage cabinet 1, a battery pack 11, and a power module 10. The battery pack 11 is connected to the power module 10 and supplies power to a load 2 by using the power module 10.

The energy storage system may include one or more battery packs 11. The battery pack 11 is configured to store electric energy and supply power to the load 2. The power module 10 is a module that can implement a power conversion function. The power module 10 can implement at least one function of DC-DC conversion, AC-AC conversion, AC-DC conversion, and DC-AC conversion. For example, the power module 10 may be a converter or another power conversion component. The converter includes a rectifier (AC-DC), an inverter (DC-AC), an alternating current converter (AC-AC), and a direct current converter (DC-DC). The power module 10 is configured to convert electric energy output by the battery pack 11 into a direct current or an alternating current required by the load 2.

The load 2 may be any electric device that uses the energy storage system as a power supply, such as a transportation means, a communication base station, a household energy storage device, or an industrial energy storage device. For example, the power module 10 can implement AC-DC conversion. A direct current output by the battery pack 11 is converted by the power module 10 into an alternating current, to be used for power consumption for living and production. Alternatively, the power module 10 can implement AC-AC conversion and AC-DC conversion. A direct current output by the battery pack 11 sequentially experiences AC-AC conversion and AC-DC conversion, to be used for power consumption for living and production.

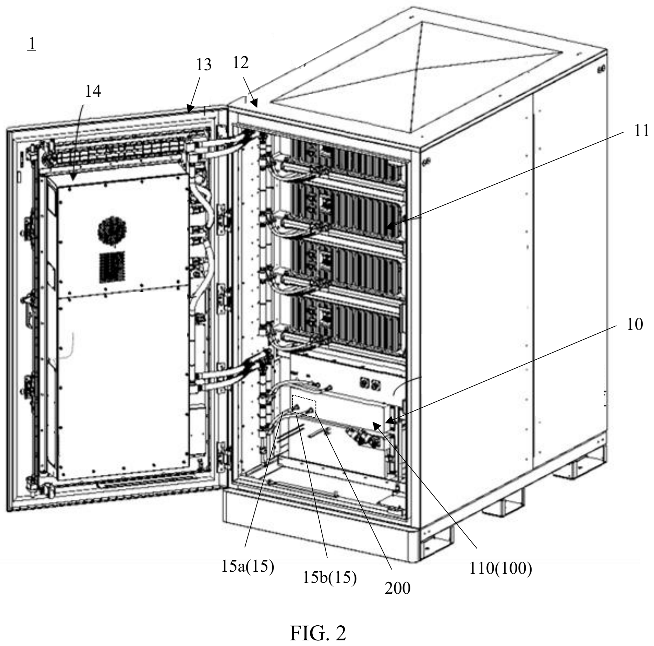

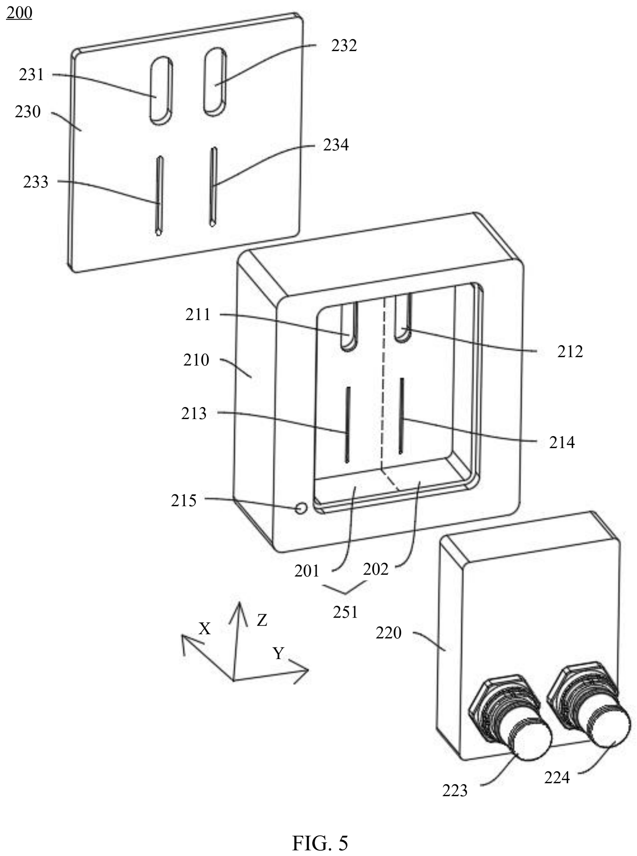

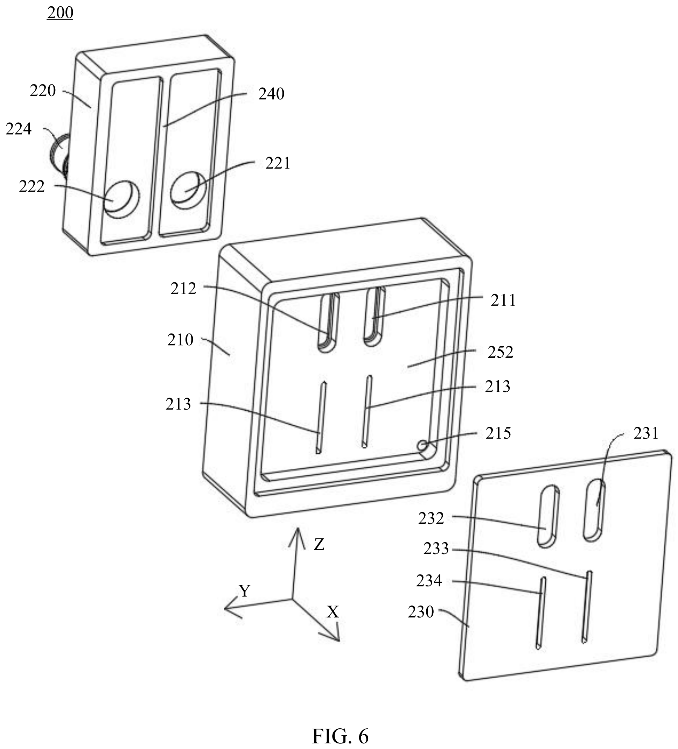

FIG. 2 is a diagram of the energy storage cabinet 1 according to an implementation of this application. In an implementation, the energy storage cabinet 1 further includes a cabinet body 12, a cabinet door 13, and a cooling assembly 14. The cabinet door 13 is configured to close the cabinet body 12. The power module 10 and the battery pack 11 are stacked inside the cabinet body 12. A front plate 110 of a housing 100 of the power module 10 faces the cabinet door 13. The cooling assembly 14 is connected to a cold plate inlet 211, a heat exchanger inlet 213, a cold plate outlet 212, and a heat exchanger outlet 214 of a connector 200 through two liquid cooling pipes 15 (with reference to FIG. 5 and FIG. 6).

The cabinet door 13 can be closed or opened relative to the cabinet body 12. Usually, the cabinet body 12 includes a battery compartment and a power compartment. The battery compartment is configured to accommodate the battery pack 11, and the power compartment is configured to accommodate the power module 10. In an implementation, the power compartment further accommodates a power distribution module configured for power distribution. In an implementation, the battery compartment and the power compartment are disposed side by side along a height direction of the energy storage cabinet 1.

The cooling assembly 14 is configured to cool a heat exchange medium discharged from the cold plate outlet 212 and the heat exchanger outlet 214 of the connector 200, and transport the cooled heat exchange medium to the power module 10 through the cold plate inlet 211 and the heat exchanger inlet 213. For example, the two liquid cooling pipes 15 are a liquid cooling pipe 15a and a liquid cooling pipe 15b. The liquid cooling pipe 15a is configured to connect the cooling assembly 14 to the cold plate outlet 212 and the heat exchanger outlet 214. The heat exchange medium discharged from the cold plate outlet 212 and the heat exchanger outlet 214 is input to the cooling assembly 14 through the liquid cooling pipe 15a. The liquid cooling pipe 15b is configured to connect the cooling assembly 14 to the cold plate inlet 211 and the heat exchanger inlet 213. The cooling assembly 14 transports the cooled heat exchange medium to the cold plate inlet 211 and the heat exchanger inlet 213 through the liquid cooling pipe 15b.

In an implementation, the cooling assembly 14 is fastened to a side that is of the cabinet door 13 and that faces the power module 10. That is, the cooling assembly 14 is fastened to the inner side of the cabinet door 13, so that internal space of the energy storage cabinet 1 can be fully used.

In an implementation, the cabinet door 13 is rotatably connected to the cabinet body 12 by using a rotating member. The rotating member is disposed to facilitate closing and opening of the cabinet door 13.

In an implementation, the connector 200 is disposed close to the rotating member (as shown in FIG. 2). The liquid cooling pipe 15 is connected to the connector 200 at a connection point close to the cabinet door 13 and the cabinet body 12, and the liquid cooling pipe 15 does not interfere with closing and opening of the cabinet door 13, so that the cabinet door 13 is closed and opened more conveniently.

In an implementation, the power module 10 may further be connected to an external power supply 3 (as shown in FIG. 1). The power module 10 receives electric energy provided by the external power supply 3 and performs power conversion on the received electric energy to charge the battery pack. The external power supply 3 may be mains, a generator, solar energy, wind energy, a battery, or the like.

In an implementation, the energy storage cabinet 1 includes two power modules 10. The two power modules 10 are a power module 10a and a power module 10b in the figure (as shown in FIG. 1). The power module 10a is a power conversion system (Power Conversion System, PCS), and the power conversion system is a DC-AC bidirectional converter, that is, the power conversion system has functions of AC-DC conversion and DC-AC conversion. The power module 10b is a module that can implement DC-DC conversion. For example, the external power supply 3 is a power grid. The power module 10a is connected to the power grid and the battery pack 11, and the power module 10a converts an alternating current provided by the power grid into a direct current to charge the battery pack 11. The electric energy output by the battery pack 11 supplies power to the load 2 by using the power module 10a or the power module 10b. In an implementation, the power module 10a is connected to the power module 10b. The electric energy output by the battery pack 11 is sequentially processed by the power module 10b and the power module 10a and then is used to supply power to the load 2.

In an implementation, the battery pack 11 may be charged when a mains price is low, and supply power to the load 2 when the mains price is high, to reduce electricity bill consumption. In an implementation, during a low power consumption period, redundant electric energy in the power grid may be stored in the battery pack 11 by using the power module 10. During a peak power consumption period, electric energy in the battery pack 11 is fed into the power grid again by using the power module 10.

In an implementation, the external power supply 3 is a photovoltaic plate (as shown in FIG. 1). The energy storage cabinet 1 is connected to the photovoltaic plate. The photovoltaic plate converts solar energy into electric energy, and the power module 10 performs power conversion on the electric energy to charge the battery pack 11. The photovoltaic plate may be connected to the power grid, to connect the generated electric energy to the power grid. The photovoltaic plate may alternatively be directly connected to an electric device, and use the generated electric energy to directly supply power to the electric device. In an implementation, when the electric energy output by the photovoltaic plate exceeds a requirement of the power grid or a requirement of the electric device for electric energy, the energy storage cabinet 1 may store, in the battery pack 11 by using the power module 10, redundant electric energy generated by the photovoltaic plate. When the electric energy output by the photovoltaic plate is less than the requirement of the power grid or the requirement of the electric device for electric energy, the battery pack 11 outputs the stored electric energy to the power grid by using the power module 10.

In an implementation, the power module 10 may be further used in another energy storage system other than the foregoing energy storage system. For example, the power module 10 may be used in a vehicle-mounted energy storage system. The vehicle-mounted energy storage system includes a vehicle-mounted battery pack 11 and a power module 10. The power module 10 can implement AC-AC conversion. A direct current output by the vehicle-mounted battery pack 11 is converted by the power module 10 to supply power to a corresponding vehicle-mounted load 2. The vehicle-mounted load 2 includes at least one of a compressor, a battery heating module, a seat heating module, a power system, a dashboard, a control display, a vehicle light, and a USB interface.

The power module 10 may be further used in another scenario in which power conversion is performed. For example, the power module 10 may be used in a charging pile. The power module 10 is a charging module in the charging pile. The charging pile receives a 220 V alternating current from mains or a 380 V alternating current from industry. The power module 10 converts the 220 V alternating current or the 380 V alternating current into a direct current, to supply power to an energy storage device in an electronic device such as a vehicle.

The power module 10 generates heat when working. To ensure stable running of the power module 10, heat dissipation is usually required for the power module. However, various components are disposed in the power module 10, and different components have different heat-generating situations. For example, the power module 10 includes components such as a power transistor, an inductor, and a capacitor. Usually, heat flux density of the power transistor is the highest, heat flux density of the inductor is the second highest, and heat flux density of the capacitor is the lowest. An existing heat dissipation system cannot meet heat dissipation requirements of the various components at the same time. Alternatively, when the heat dissipation system can meet the heat dissipation requirements of the various components, energy consumption and costs of the heat dissipation system are high, and a volume of the heat dissipation system is large, which makes it difficult to miniaturize the power module 10.

The power module 10 provided in this application can meet heat dissipation requirements of different components, and also reduce costs.

The following describes in detail the power module 10 in this application.

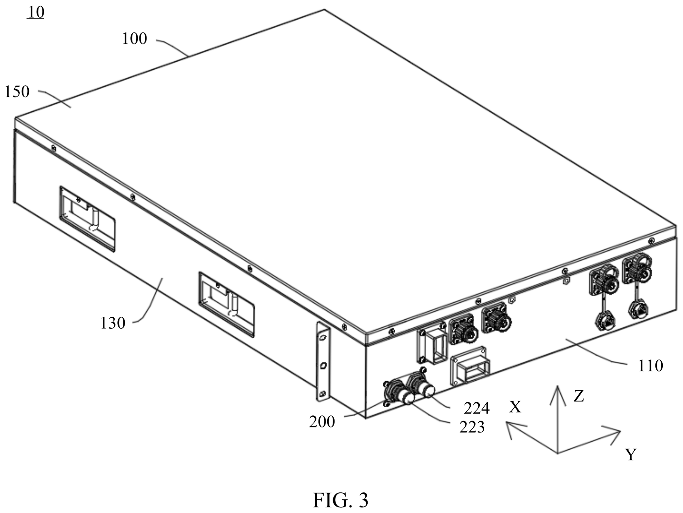

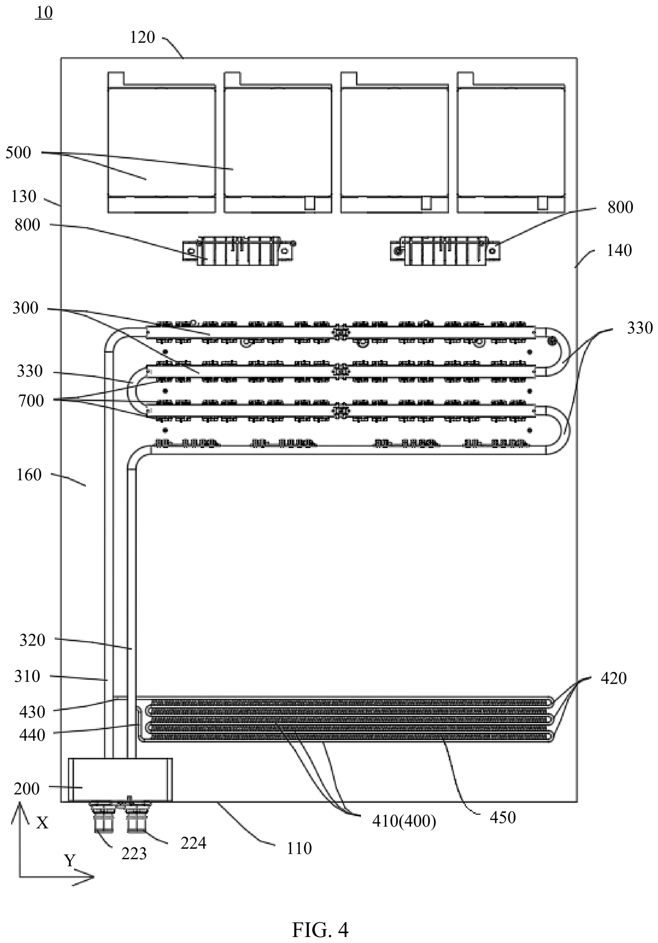

Refer to FIG. 3, FIG. 4, FIG. 5, and FIG. 6. FIG. 3 is a three-dimensional diagram of the power module 10 according to an implementation of this application. FIG. 4 is a diagram of the power module 10 according to an implementation of this application. FIG. 5 and FIG. 6 are both exploded views of the connector 200 according to an implementation of this application.

This application provides the power module 10. The power module 10 includes the housing 100, the connector 200, an inductor 500, a cold plate 300, and an air-liquid heat exchanger 400 (as shown in FIG. 3 and FIG. 4). The connector 200, the air-liquid heat exchanger 400, the cold plate 300, and the inductor 500 are sequentially arranged inside the housing 100 along a first direction X. The housing 100 includes the front plate 110 and a rear plate 120, and the front plate 110 and the rear plate 120 are oppositely arranged along the first direction X. The connector 200 is arranged between the air-liquid heat exchanger 400 and the front plate 110 along the first direction X. The connector 200 includes the cold plate inlet 211, the heat exchanger inlet 213, the cold plate outlet 212, and the heat exchanger outlet 214 (as shown in FIG. 5 and FIG. 6). Along a second direction Y, the cold plate inlet 211 and the cold plate outlet 212 are adjacently arranged, and the heat exchanger inlet 213 and the heat exchanger outlet 214 are adjacently arranged. The second direction Y is perpendicular to the first direction X. Along a third direction Z, the heat exchanger inlet 213 and one of the cold plate inlet 211 and the cold plate outlet 212 are adjacently arranged, and the heat exchanger outlet 214 and the other one of the cold plate inlet 211 and the cold plate outlet 212 are adjacently arranged. The third direction Z is perpendicular to the second direction Y and the first direction X.

The housing 100 is configured to form enclosed space to accommodate components such as the connector 200, the inductor 500, the cold plate 300, and the air-liquid heat exchanger 400. The housing 100 isolates the component located inside the housing 100 from an external environment, to avoid a decrease in long-term working reliability, an increase in a failure rate, a decrease in component service life, and the like of the power module 10 that are caused by long-term contact between the component such as the inductor 500 and an external corrosive substance, dust, and water vapor. The housing 100 is disposed, to improve reliability of the power module 10.

The inductor 500 is one of components in the power module 10 for implementing power conversion. The inductor 500 is located between the rear plate 120 and the cold plate 300 along the first direction X (as shown in FIG. 4). Usually, a volume of the inductor 500 is large. The inductor 500 is disposed at one end that is of the housing 100 and that is close to the rear plate 120 along the first direction X, to avoid obstructing arrangement of other components in the housing 100 and facilitate miniaturization of the power module 10.

The cold plate 300 is configured to cool a heat-generating component in the power module 10, especially a heat-generating component that generates high heat. For example, the cold plate 300 may be configured to cool a power transistor 700 (as shown in FIG. 4). A heat exchange medium flows in the cold plate 300. The heat exchange medium in the cold plate 300 is in close contact with the heat-generating component and performs heat exchange with the heat-generating component, to cool the heat-generating component. In an implementation, the cold plate 300 may also cool air in the housing 100, and then cool the heat-generating component by using the air in the housing 100.

The air-liquid heat exchanger 400 is configured to cool the heat-generating component in the power module 10. A heat exchange medium flows in the air-liquid heat exchanger 400. The heat exchange medium in the air-liquid heat exchanger 400 can perform heat exchange with the air in the housing 100 to cool the air in the housing 100. When low-temperature air flows through the heat-generating component, the heat-generating component may be cooled. The low-temperature air absorbs heat of the heat-generating component, and then a temperature rises. High-temperature air may be cooled again when flowing through the air-liquid heat exchanger 400. In an implementation, the power module 10 further includes heat-generating components such as a capacitor, a relay, a transformer, a lightning arrester, and Hall. The air-liquid heat exchanger 400 may be configured to cool the heat-generating components such as the inductor 500, the capacitor, the relay, the transformer, the lightning arrester, and the Hall.

Both the cold plate 300 and the air-liquid heat exchanger 400 are connected to the connector 200 (as shown in FIG. 4). The connector 200 is located in the housing 100, and along the first direction X, the connector 200 is located at one end that is of the housing 100 and that is close to the front plate 110. In one implementation, the connector 200 is fastened to the front plate 110. Usually, a gap is provided between the air-liquid heat exchanger 400 and the front plate 110, to facilitate installation of the air-liquid heat exchanger 400 and prevent damage to the air-liquid heat exchanger 400 caused by contact between the air-liquid heat exchanger 400 and the front plate 110. In this case, the connector 200 is disposed in the gap between the air-liquid heat exchanger 400 and the front plate 110, so that internal space of the housing 100 can be fully used.

The cold plate inlet 211 in the connector 200 is configured to communicate with an inlet of the cold plate 300 and is configured to transport the heat exchange medium to the cold plate 300. The cold plate outlet 212 is configured to communicate with an outlet of the cold plate 300 and is configured to receive the heat exchange medium discharged from the cold plate 300. The heat exchanger inlet 213 is configured to communicate with an inlet of the air-liquid heat exchanger 400 and is configured to transport the heat exchange medium to the air-liquid heat exchanger 400. The heat exchanger outlet 214 is configured to communicate with an outlet of the air-liquid heat exchanger 400 and is configured to receive the heat exchange medium discharged from the air-liquid heat exchanger 400.

An arrangement direction of the cold plate inlet 211 and the cold plate outlet 212 is parallel to an arrangement direction of the heat exchanger inlet 213 and the heat exchanger outlet 214 (as shown in FIG. 5 and FIG. 6). The cold plate inlet 211 and the heat exchanger inlet 213 are arranged along the third direction Z, and the cold plate outlet 212 and the heat exchanger outlet 214 are arranged along the third direction Z. Alternatively, the cold plate inlet 211 and the heat exchanger outlet 214 are arranged along the third direction Z, and the cold plate outlet 212 and the heat exchanger inlet 213 are arranged along the third direction Z. The cold plate inlet 211, the heat exchanger inlet 213, the cold plate outlet 212, and the heat exchanger outlet 214 in the connector 200 are arranged in an orderly manner. Orderly arrangement of various inlets and outlets in the connector 200 is conducive to reducing a size of the connector 200.

In an implementation, the first direction X is a length direction of the power module 10, the second direction Y is a width direction of the power module 10, and the third direction Z is a height direction of the power module 10.

According to the power module 10 provided in this application, on one hand, the cold plate 300 and the air-liquid heat exchanger 400 are disposed in the power module 10, so that good heat dissipation effect can be achieved for the power module 10. The cold plate 300 has a strong heat dissipation capability for the heat-generating component. The cold plate 300 is configured to dissipate heat for the high-heat-generating component, so that a heat dissipation requirement of the high-heat-generating component can be met, and good heat dissipation effect can be achieved for the high-heat-generating component. The air-liquid heat exchanger 400 is configured to dissipate heat for various heat-generating components in the housing 100.

It may be understood that, if the power module 10 includes only the air-liquid heat exchanger 400 for heat dissipation, the air-liquid heat exchanger 400 needs to have a large volume to meet heat dissipation requirements of the various heat-generating components in the housing 100. However, in this application, the high-heat-generating component is cooled by the cold plate 300, and other heat-generating components in the housing 100 generate low heat. In this case, the air-liquid heat exchanger 400 can achieve good heat dissipation effect for the other heat-generating components with a small volume.

It may be understood that, if the power module 10 includes only the cold plate 300 for heat dissipation, a cold plate 300 needs to be disposed for each heat-generating component. A quantity of the cold plates 300 is large, and this increases costs of the power module 10 and complexity of a heat dissipation system including the cold plate 300. However, in this application, the cold plate 300 is configured to cool the high-heat-generating component, and other heat-generating components may be cooled by using the air-liquid heat exchanger 400, so that heat dissipation costs of the power module 10 are reduced. A heat dissipation system including the cold plate 300 and the air-liquid heat exchanger 400 has a simple structure and few parts, and is easy to install in the housing 100.

According to the power module 10 provided in this application, a composite heat dissipation system in which the cold plate 300 is combined with the air-liquid heat exchanger 400 is used to dissipate heat for the power module 10, so that good heat dissipation effect can be achieved for the various heat-generating components in the housing 100, heat dissipation costs of the power module 10 can be reduced, complexity of the heat dissipation system in the power module 10 can be reduced, and a volume of the power module 10 can also be reduced.

On another hand, the cold plate 300 and the air-liquid heat exchanger 400 are connected to a same connector 200, and receive the heat exchange medium and discharge the heat exchange medium by using the same connector 200. The cold plate 300 and the air-liquid heat exchanger 400 are connected to the connector 200 in a centralized manner, so that a quantity of connectors 200 is reduced, and heat dissipation pipeline arrangement in the power module 10 is more orderly.

On still another hand, the connector 200, the air-liquid heat exchanger 400, the cold plate 300, and the inductor 500 are sequentially arranged inside the housing 100 along the first direction X. In this arrangement manner, internal space of the housing 100 can be fully used, to facilitate reduction in the volume of the power module 10. A proper layout of the components in the housing 100 is conducive to improving reliability of the power module 10.

In a possible implementation, the housing 100 includes a first side plate 130 and a second side plate 140. The first side plate 130 and the second side plate 140 are oppositely arranged along the second direction Y. The connector 200, the air-liquid heat exchanger 400, the cold plate 300, and the inductor 500 are arranged between the first side plate 130 and the second side plate 140. Along the second direction Y, a distance between the connector 200 and the first side plate 130 is less than a distance between the connector 200 and the second side plate 140. Along the second direction Y, the connector 200 is closer to the first side plate 130 than to the second side plate 140.

In an implementation, the power module 10 is installed in the energy storage cabinet 1 (with reference to FIG. 2 and FIG. 4). Compared with the second side plate 140, the first side plate 130 is closer to the rotating member between the cabinet door 13 and the cabinet body 12. The connector 200 is disposed closer to the first side plate 130, to facilitate a connection of the connector 200 to the cooling assembly 14.

In a possible implementation, along the second direction Y, the distance between the connector 200 and the first side plate 130 is less than a distance between the air-liquid heat exchanger 400 and the first side plate 130 (as shown in FIG. 4), and the distance between the connector 200 and the second side plate 140 is greater than a distance between the air-liquid heat exchanger 400 and the second side plate 140. The air-liquid heat exchanger 400 is spaced from the first side plate 130 and the second side plate 140 along the second direction Y. A gap between the air-liquid heat exchanger 400 and the first side plate 130 is used for the air-liquid heat exchanger 400 to be installed in and a connection pipeline between the air-liquid heat exchanger 400 and the connector 200 to be arranged in. A gap between the air-liquid heat exchanger 400 and the second side plate 140 is used for the air-liquid heat exchanger 400 to be installed in.

Usually, to ensure heat dissipation effect of the air-liquid heat exchanger 400, a length of the air-liquid heat exchanger 400 along the second direction Y is long, and the distances between the air-liquid heat exchanger 400 and the first side plate 130 and between the air-liquid heat exchanger 400 and the second side plate 140 are small. In the power module 10 provided in this application, the distance between the connector 200 and the first side plate 130 is less than the distance between the air-liquid heat exchanger 400 and the first side plate 130, the distance between the connector 200 and the first side plate 130 is small, the distance between the connector 200 and the second side plate 140 is large, and the connector 200 is disposed closer to the first side plate 130. On one hand, the connector 200 is located in a corner between the first side plate 130 and the front plate 110, which improves utilization of internal space of the housing 100 and reduces impact on arrangement of other components and wires. On another hand, a connection route between the connector 200 and the cooling assembly 14 is shorter, so that pipeline arrangement in the energy storage cabinet 1 is simpler.

In a possible implementation, along the second direction Y, at least one of a spacing between the cold plate inlet 211 and the cold plate outlet 212 or a spacing between the heat exchanger inlet 213 and the heat exchanger outlet 214 is less than the spacing between the air-liquid heat exchanger 400 and the first side plate 130 (with reference to FIG. 4 and FIG. 5).

In an implementation, along the second direction Y, the spacing between the cold plate inlet 211 and the cold plate outlet 212 is less than the spacing between the air-liquid heat exchanger 400 and the first side plate 130. The spacing between the air-liquid heat exchanger 400 and the first side plate 130 is small, and the spacing between the cold plate inlet 211 and the cold plate outlet 212 is less than the spacing between the air-liquid heat exchanger 400 and the first side plate 130, so that the cold plate inlet 211 and the cold plate outlet 212 are tightly arranged, to facilitate reduction in a size of the connector 200 along the second direction Y.

In an implementation, along the second direction Y, the spacing between the heat exchanger inlet 213 and the heat exchanger outlet 214 is less than the spacing between the air-liquid heat exchanger 400 and the first side plate 130. The spacing between the air-liquid heat exchanger 400 and the first side plate 130 is small, and the spacing between the heat exchanger inlet 213 and the heat exchanger outlet 214 is less than the spacing between the air-liquid heat exchanger 400 and the first side plate 130, so that the heat exchanger inlet 213 and the heat exchanger outlet 214 are tightly arranged, to facilitate reduction in the size of the connector 200 along the second direction Y

In an implementation, along the second direction Y, the spacing between the cold plate inlet 211 and the cold plate outlet 212 and the spacing between the heat exchanger inlet 213 and the heat exchanger outlet 214 are both less than the spacing between the air-liquid heat exchanger 400 and the first side plate 130, so that the size of the connector 200 along the second direction Y can be smaller.

In an implementation, the power module 10 further includes a liquid inlet pipe 310 of the cold plate and a liquid outlet pipe 320 of the cold plate (as shown in FIG. 4 and FIG. 5). The liquid inlet pipe 310 of the cold plate is configured to communicate the inlet of the cold plate 300 with the cold plate inlet 211 of the connector 200. The liquid outlet pipe 320 of the cold plate is configured to communicate the outlet of the cold plate 300 with the cold plate outlet 212 of the connector 200. The spacing between the cold plate inlet 211 and the cold plate outlet 212 is small, so that the liquid inlet pipe 310 of the cold plate and the liquid outlet pipe 320 of the cold plate are centralized, to facilitate sealing processing on a connection point between the liquid inlet pipe 310 of the cold plate and the connector 200 and a connection point between the liquid outlet pipe 320 of the cold plate and the connector 200.

In an implementation, the power module 10 further includes a liquid inlet pipe 430 of the heat exchanger and a liquid outlet pipe 440 of the heat exchanger (as shown in FIG. 4 and FIG. 5). The liquid inlet pipe 430 of the heat exchanger is configured to communicate the inlet of the air-liquid heat exchanger 400 with the heat exchanger inlet 213 of the connector 200. The liquid outlet pipe 440 of the heat exchanger is configured to communicate the outlet of the air-liquid heat exchanger 400 with the heat exchanger outlet 214 of the connector 200. The spacing between the heat exchanger inlet 213 and the heat exchanger outlet 214 is small, so that the liquid inlet pipe 430 of the heat exchanger and the liquid outlet pipe 440 of the heat exchanger are centralized, to facilitate sealing processing on a connection point between the liquid inlet pipe 430 of the heat exchanger and the connector 200 and a connection point between the liquid outlet pipe 440 of the heat exchanger and the connector 200.

In a possible implementation, the connector 200 includes a first sub-cavity 201 and a second sub-cavity 202 (as shown in FIG. 5 and FIG. 6). The first sub-cavity 201 and the second sub-cavity 202 are adjacently arranged and spaced apart along the second direction Y. The first sub-cavity 201 is configured to communicate with the cold plate inlet 211 and the heat exchanger inlet 213. The second sub-cavity 202 is configured to communicate with the cold plate outlet 212 and the heat exchanger outlet 214. A flow path of the cold plate 300 and a flow path of the air-liquid heat exchanger 400 run in parallel. The cold plate 300 and the air-liquid heat exchanger 400 receive the heat exchange medium through the first sub-cavity 201, and discharge the heat exchange medium through the second sub-cavity 202. Along the third direction Z, the cold plate inlet 211 and the heat exchanger inlet 213 are adjacently arranged, and the cold plate outlet 212 and the heat exchanger outlet 214 are adjacently arranged.

The first sub-cavity 201 and the second sub-cavity 202 are provided, so that the cold plate 300 and the air-liquid heat exchanger 400 run in parallel. This improves heat dissipation efficiency of the power module 10. The two liquid cooling pipes 15 of the cooling assembly 14 respectively communicate with the first sub-cavity 201 and the second sub-cavity 202, so that the cooling assembly 14 can be connected to the cold plate inlet 211, the heat exchanger inlet 213, the cold plate outlet 212, and the heat exchanger outlet 214. On one hand, a quantity of pipes between the cooling assembly 14 and the connector 200 is reduced. On another hand, a quantity of joints that are in the connector 200 and that are configured to connect to the liquid cooling pipe 15 of the cooling assembly 14 is reduced, so that a volume of the connector 200 is reduced, to facilitate miniaturization of the power module 10.

In an implementation, the connector 200 includes a connection base 210, a first cover 220, and a partition plate 240 (as shown in FIG. 5 and FIG. 6). The connection base 210 includes a first groove. The cold plate inlet 211, the cold plate outlet 212, the heat exchanger inlet 213, and the heat exchanger outlet 214 each penetrate a groove bottom of the first groove along the first direction X. The partition plate 240 is located in the first groove and is configured to divide the first groove along the second direction Y. An outer peripheral surface of the first cover 220 is fastened to a groove wall of the first groove, and a surface that is of the first cover 220 and that faces the groove bottom of the first groove is fastened to the partition plate 240. The groove bottom of the first groove and the first cover 220 are spaced apart along the first direction X. The connection base 210 and the first cover 220 enclose to form a first cavity 251, and the partition plate 240 divides the first cavity 251 to form the first sub-cavity 201 and the second sub-cavity 202.

In a possible implementation, the connector 200 further includes a second cavity 252 and a liquid discharge hole 215 (as shown in FIG. 5 and FIG. 6). The second cavity 252 and the first sub-cavity 201 or the second sub-cavity 202 are adjacently arranged and spaced apart along the first direction X. The liquid discharge hole 215 communicates with the second cavity 252. The second cavity 252 and the first cavity 251 are arranged along the first direction. The second cavity 252 is isolated from the first cavity 251. The power module 10 further includes the liquid inlet pipe 310 of the cold plate, the liquid outlet pipe 320 of the cold plate, the liquid inlet pipe 410 of the heat exchanger, and the liquid outlet pipe 440 of the heat exchanger. One end of the liquid inlet pipe 310 of the cold plate, one end of the liquid outlet pipe 320 of the cold plate, one end of the liquid inlet pipe 430 of the heat exchanger, and one end of the liquid outlet pipe 440 of the heat exchanger are all connected to the connection base 210 of the connector 200.

Usually, to prevent leakage of the heat exchange medium from affecting normal running of the component in the power module 10, sealing processing is usually performed on connection points between the connection base 210 and the liquid inlet pipe 310 of the cold plate, the liquid outlet pipe 320 of the cold plate, the liquid inlet pipe 430 of the heat exchanger, and the liquid outlet pipe 440 of the heat exchanger. In an implementation, the liquid inlet pipe 310 of the cold plate, the liquid outlet pipe 320 of the cold plate, the liquid inlet pipe 430 of the heat exchanger, and the liquid outlet pipe 440 of the heat exchanger are welded to the connection base 210, and are sealed with the connection base 210 through a welding seam.

However, in a process of using the power module 10, a problem of inadequate sealing may occur at the connection points between the connection base 210 and the liquid inlet pipe 310 of the cold plate, the liquid outlet pipe 320 of the cold plate, the liquid inlet pipe 430 of the heat exchanger, and the liquid outlet pipe 440 of the heat exchanger. The heat exchange medium may leak to a side that is of the connection base 210 and that faces away from the first cavity 251. In the power module 10 provided in this application, the second cavity 252 is provided on the side that is of the connection base 210 and that faces away from the first cavity 251. The leaked heat exchange medium is collected in the second cavity 252, and is discharged out of the second cavity 252 through the liquid discharge hole 215. The second cavity 252 is provided to seal the connector 200 for a second time, to reduce a risk that the leaked liquid causes damage to the component in the housing 100. In an implementation, the heat exchange medium discharged from the liquid discharge hole 215 may be discharged out of the housing 100 through a pipeline.

In an implementation, a volume of the second cavity 252 is smaller than a volume of the first cavity 251. The volume of the first cavity 251 is large, which can ensure that the heat exchange medium can be smoothly supplied to the cold plate 300 and the air-liquid heat exchanger 400, and that the heat exchange medium discharged from the cold plate 300 and the air-liquid heat exchanger 400 can be smoothly discharged out of the connector 200. The second cavity 252 is mainly configured to prevent the leaked heat exchange medium from entering the housing 100. The second cavity 252 is configured to temporarily store the heat exchange medium. The heat exchange medium in the second cavity 252 is quickly discharged out of the housing 100 through the liquid discharge hole 215. The volume of the second cavity 252 is small, so that the leaked heat exchange medium can be prevented from damaging the component in the housing 100. Reducing the volume of the second cavity 252 is conducive to reducing the size of the connector 200.

In a possible implementation, the connector 200 includes the first cover 220, the connection base 210, a second cover 230, and the partition plate 240 (as shown in FIG. 5 and FIG. 6). The first cover 220 and the second cover 230 are arranged on two sides of the connection base 210 along the first direction X, and respectively enclose with the two sides of the connection base 210 to form the first cavity 251 and the second cavity 252. The partition plate 240 is located in the first cavity 251 and is configured to divide the first cavity 251 to form the first sub-cavity 201 and the second sub-cavity 202. The connection base 210 includes the cold plate inlet 211, the cold plate outlet 212, the heat exchanger inlet 213, and the heat exchanger outlet 214. The cold plate inlet 211, the cold plate outlet 212, the heat exchanger inlet 213, and the heat exchanger outlet 214 penetrate the connection base 210 along the first direction X. The first cover 220 includes a liquid inlet hole 221 and a liquid outlet hole 222. The liquid inlet hole 221 and the liquid outlet hole 222 each penetrate the first cover 220 along the first direction X. The liquid inlet hole 221 is configured to communicate with at least one of the cooling inlet hole 211 or the heat exchange inlet hole 213. The liquid outlet hole 222 is configured to communicate with at least one of the cold plate outlet 212 or the heat exchanger outlet 214. The second cover 230 includes a first opening 231, a second opening 232, a third opening 233, and a fourth opening 234. The first opening 231, the second opening 232, the third opening 233, and the fourth opening 234 each penetrate the second cover 230 along the first direction X. The first opening 231, the second opening 232, the third opening 233, and the fourth opening 234 are respectively arranged opposite to the cold plate inlet 211, the cold plate outlet 212, the heat exchanger inlet 213, and the heat exchanger outlet 214 along the first direction X.

The liquid inlet hole 221 and the liquid outlet hole 222 on the first cover 220 are configured to respectively communicate with the two liquid cooling pipes 15 of the cooling assembly 14 (with reference to FIG. 2 and FIG. 6). The first sub-cavity 201 receives, through the liquid inlet hole 221, the heat exchange medium transmitted by the cooling assembly 14, and respectively transports the received heat exchange medium to the cold plate 300 and the air-liquid heat exchanger 400 through the cold plate inlet 211 and the heat exchanger inlet 213. The heat exchange medium flowing out of the cold plate 300 and the air-liquid heat exchanger 400 flows into the second sub-cavity 202 through the cold plate outlet 212 and the heat exchanger outlet 214 respectively, and the heat exchange medium in the second sub-cavity 202 is transported to the cooling assembly 14 through the liquid outlet hole 222.

The connection base 210 further includes a second groove, and the second groove and the first groove are arranged along the first direction X. An outer peripheral surface of the second cover 230 is fastened to a groove wall of the second groove. The second cover 230 and a groove bottom of the second groove are spaced apart to form the second cavity 252. The connection base 210 further includes the liquid discharge hole 215, and the liquid discharge hole 215 penetrates the connection base 210 along the first direction X. A projection of the second cover 230 along the first direction covers a projection of the liquid discharge hole 215 along the first direction.

In an implementation, a projection of the first cover 220 along the first direction X does not overlap the projection of the liquid discharge hole 215 along the first direction X (as shown in FIG. 5). Along the first direction X, a projection of the first cover 220 on the connection base 210 covers a part of the connection base 210, and the liquid discharge hole 215 is provided in a region that is of the connection base 210 and that is not covered by the projection of the first cover 220. The liquid discharge hole 215 only needs to penetrate the connection base 210 to discharge, out of the connector 200, the heat exchange medium that leaks into the second cavity 252.

In an implementation, the housing 100 includes a top plate 150 and a bottom plate 160. The top plate 150 and the bottom plate 160 are arranged along the third direction Z. Along the third direction Z, a distance between the liquid discharge hole 215 and the bottom plate 160 is less than a distance between the heat exchanger inlet 213 or the heat exchanger outlet 214 and the bottom plate 160. The liquid discharge hole 215 is provided close to the bottom plate 160, which is conducive to quick discharge of the heat exchange medium in the second cavity 252, and is further conducive to complete discharge of the heat exchange medium in the second cavity 252, to avoid accumulation of the heat exchange medium in the second cavity 252.

The second cover 230 is provided with the first opening 231, the second opening 232, the third opening 233, and the fourth opening 234 (as shown in FIG. 5 and FIG. 6). Along the second direction Y, the first opening 231 and the second opening 232 are adjacently arranged, and the third opening 233 and the fourth opening 234 are adjacently arranged. Along the third direction Z, the first opening 231 and the third opening 233 are adjacently arranged, and the second opening 232 and the fourth opening 234 are adjacently arranged. The power module 10 further includes the liquid inlet pipe 310 of the cold plate, the liquid outlet pipe 320 of the cold plate, the liquid inlet pipe 430 of the heat exchanger, and the liquid outlet pipe 440 of the heat exchanger (with reference to FIG. 4). The liquid inlet pipe 310 of the cold plate extends into the second cavity 252 through the first opening 231 and is fastened to an inner wall of the cold plate inlet 211. The liquid outlet pipe 320 of the cold plate extends into the second cavity 252 through the second opening 232 and is fastened to an inner wall of the cold plate outlet 212. The liquid inlet pipe 430 of the heat exchanger extends into the second cavity 252 through the third opening 233 and is fastened to an inner wall of the heat exchanger inlet 213. The liquid outlet pipe 440 of the heat exchanger extends into the second cavity 252 through the fourth opening 234 and is fastened to an inner wall of the heat exchanger outlet 214.

Along the first direction X, the first opening 231 and the cold plate inlet 211 are oppositely arranged. A distance between the first opening 231 and the cold plate inlet 211 is short. When the liquid inlet pipe 310 of the cold plate is connected to the cold plate inlet 211, a pipeline is short and does not need to be bent. This reduces costs, reduces a risk of bending and breaking the liquid inlet pipe 310 of the cold plate, and also improves reliability of a connection between the liquid inlet pipe 310 of the cold plate and the cold plate inlet 211. Similarly, along the first direction X, the second opening 232 and the cold plate outlet 212 are oppositely arranged, the third opening 233 and the heat exchanger inlet 213 are oppositely arranged, and the fourth opening 234 and the heat exchanger outlet 214 are oppositely arranged. This can also reduce costs and improve reliability of connections between the connection base 210 and the liquid outlet pipe 320 of the cold plate, the liquid inlet pipe 430 of the heat exchanger, and the liquid outlet pipe 440 of the heat exchanger.

In a possible implementation, the power module 10 includes a liquid inlet joint 223 and a liquid outlet joint 224 (as shown in FIG. 5 and FIG. 6). The liquid inlet joint 223 and the liquid outlet joint 224 are fastened to the first cover 220 and are respectively connected to the liquid inlet hole 221 and the liquid outlet hole 222. The front plate 110 includes a through hole 111, and the through hole 111 penetrates the front plate 110 along the first direction X. Along the first direction X, a projection of the through hole 111 covers a projection of the liquid inlet joint 223 and a projection of the liquid outlet joint 224, and the projection of the first cover 220 covers the projection of the through hole 111. Along the third direction Z, lengths of the liquid inlet joint 223 and the liquid outlet joint 224 are greater than a distance between the first cover 220 and the front plate 110.

The liquid inlet joint 223 is configured to connect the liquid inlet hole 221 and the cooling assembly 14, and the liquid outlet joint 224 is configured to connect the liquid outlet hole 222 and the cooling assembly. Along the first direction X, the liquid inlet joint 223 and the liquid outlet joint 224 extend from the inside of the housing 100 to the outside of the housing 100 through the through hole 111. The power module 10 may be connected to the cooling assembly 14 outside the housing 100. A case in which the power module 10 is connected to the two liquid cooling pipes 15 of the cooling assembly 14 outside the housing 100 by using the liquid inlet joint 223 and the liquid outlet joint 224 is different from a case in which the power module 10 is connected to the cooling assembly 14 inside the housing 100 in the following ways. On one hand, operation space outside the housing 100 is larger, which facilitates connections of the two liquid cooling pipes 15 to the liquid inlet joint 223 and the liquid outlet joint 224. On another hand, a connection point between the power module 10 and the liquid cooling pipe 15 is provided outside the housing 100. If the heat exchange medium leaks due to a loose connection between the joint and the pipe during long-term running of the power module 10, the leaked heat exchange medium is located outside the housing 100, to avoid damage to the component in the housing 100.

In addition, along the first direction X, the projection of the first cover 220 covers the projection of the through hole 111, and an area of the first cover 220 is greater than an area of the through hole 111. The area of the through hole 111 is small, so that sealing performance of the housing 100 is ensured.

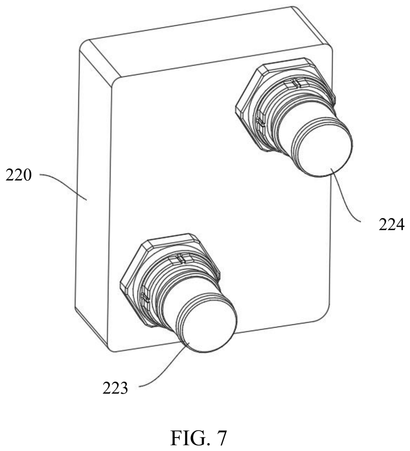

In the implementation shown in FIG. 5, the liquid inlet joint 223 and the liquid outlet joint 224 are adjacently arranged and spaced apart along the second direction Y. In an implementation, the liquid inlet joint 223 and the liquid outlet joint 224 may be disposed diagonally on the first cover 220 (as shown in FIG. 7). Correspondingly, the liquid inlet hole 221 and the liquid outlet hole 222 are also provided diagonally on the first cover 220. The liquid inlet joint 223 and the liquid outlet joint 224 are far away from each other. When the liquid inlet joint 223 and the liquid outlet joint 224 are connected to the liquid cooling pipe 15, there is large operation space, to facilitate connections of the liquid inlet joint 223 and the liquid outlet joint 224 to the liquid cooling pipe 15. In addition, the liquid inlet joint 223 and the liquid outlet joint 224 are disposed in a staggered manner, so that the size of the connector 200 along the second direction Y can be reduced when it is ensured that the liquid inlet joint 223 and the liquid outlet joint 224 have an adequate distance for connecting to the liquid cooling pipe 15.

In an implementation, a sealing member is disposed between the first cover 220 and the front plate 110 along the first direction X, and the sealing member is disposed around the through hole 111. The sealing member is configured to prevent substances such as water vapor, air, and dust in the external environment from entering the housing 100 through the through hole 111 and a gap between the first cover 220 and the front plate 110, and ensure stable running of the power module 10. In this application, because the area of the through hole 111 is small, the sealing member may be correspondingly made small, and reliability of the sealing member is high when the sealing member is configured for sealing. This improves sealing performance of the housing 100, so that the component in the housing 100 is better protected.

In this application, because the cold plate 300 and the air-liquid heat exchanger 400 are configured to perform heat dissipation inside the housing 100, and the cold plate 300 and the air-liquid heat exchanger 400 receive the heat exchange medium outside the housing 100 and discharge the heat exchange medium out of the housing 100 only through the small through hole 111, after the sealing member is disposed to seal a gap between a periphery side of the through hole 111 and the first cover 220, overall sealing performance of the housing 100 is high, and a protection level is high, which improves long-term working reliability of the power module 10, reduces the failure rate of the component in the housing 100, and prolongs the component service life.

In an implementation, the projection of the through hole 111 covers the projection of the liquid discharge hole 215 along the first direction X, so that the heat exchange medium in the second cavity 252 is discharged out of the housing 100 through the liquid discharge hole 215 and the through hole 111.

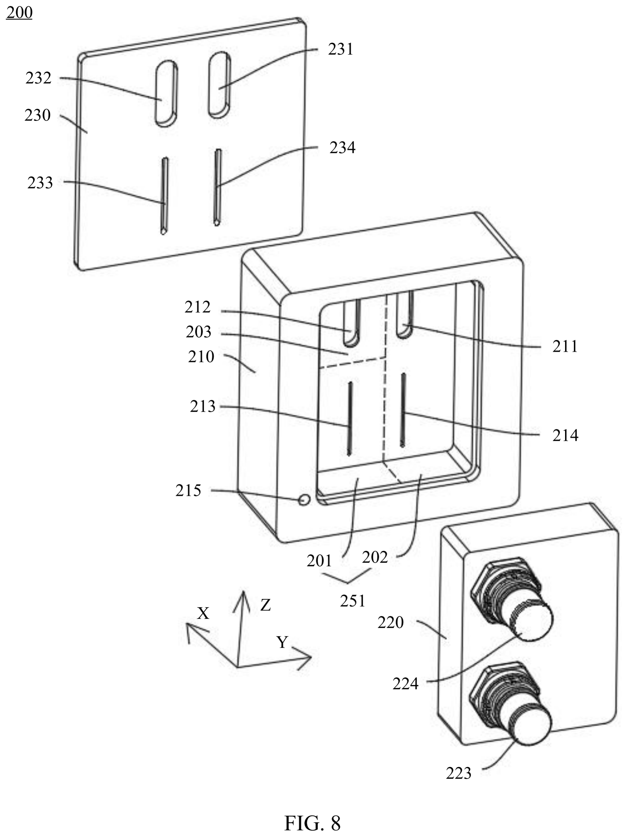

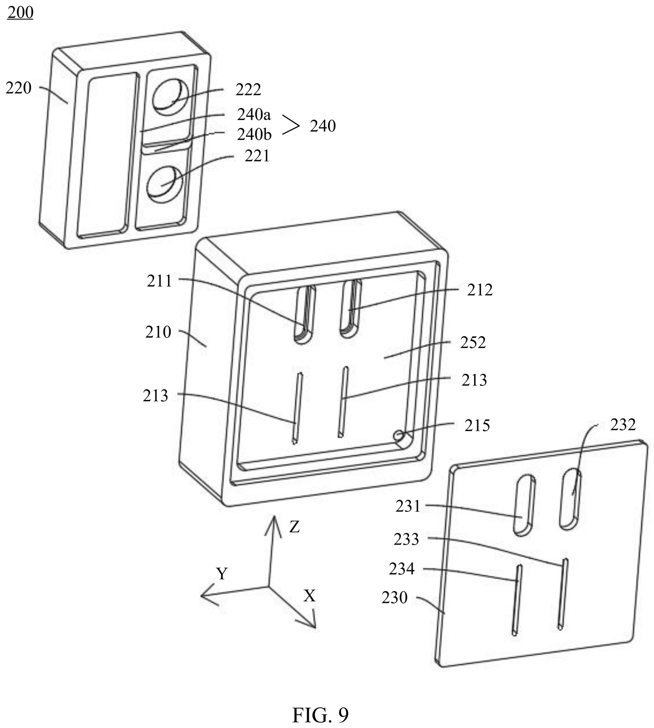

FIG. 8 and FIG. 9 are exploded views of the connector 200 according to an implementation of this application. In a possible implementation, the connector 200 includes the first sub-cavity 201, the second sub-cavity 202, and a third sub-cavity 203. The first sub-cavity 201 and the third sub-cavity 203 are adjacently arranged and spaced apart along the third direction Z. The first sub-cavity 201 or the third sub-cavity 203 and the second sub-cavity 202 are adjacently arranged and spaced apart along the second direction Y. The first sub-cavity 201 is configured to communicate with the heat exchanger inlet 213. The second sub-cavity 202 is configured to communicate with the heat exchanger outlet 214 and the cold plate inlet 211. The third sub-cavity 203 is configured to communicate with the cold plate outlet 212.

The flow path of the cold plate 300 and the flow path of the air-liquid heat exchanger 400 run in series. An inlet of the air-liquid heat exchanger 400 communicates with the first sub-cavity 201 and receives the heat exchange medium through the first sub-cavity 201. The outlet of the air-liquid heat exchanger 400 and the inlet of the cold plate 300 communicate with the second sub-cavity 202. The heat exchange medium discharged from the outlet of the air-liquid heat exchanger 400 to the second sub-cavity 202 can be transported to the cold plate 300. The outlet of the cold plate 300 communicates with the third sub-cavity 203, and transports the heat exchange medium to the cooling assembly 14 through the third sub-cavity 203.

The first sub-cavity 201, the second sub-cavity 202, and the third sub-cavity 203 are provided, so that the cold plate 300 and the air-liquid heat exchanger 400 run in series. This can reduce heat dissipation energy consumption of the power module 10. The two liquid cooling pipes 15 of the cooling assembly 14 communicate with the first sub-cavity 201 and the third sub-cavity 203, so that the cooling assembly 14 can be connected to the cold plate inlet 211, the heat exchanger inlet 213, the cold plate outlet 212, and the heat exchanger outlet 214. On one hand, the quantity of pipes between the cooling assembly 14 and the connector 200 is reduced. On another hand, the quantity of joints that are in the connector 200 and that are configured to connect to the liquid cooling pipe 15 of the cooling assembly 14 is reduced, so that the volume of the connector 200 is reduced, to facilitate miniaturization of the power module 10.

On still another hand, because the cold plate 300 is mainly configured to dissipate heat for the high-heat-generating component, and the air-liquid heat exchanger 400 is mainly configured to dissipate heat for medium- and low-heat-generating components, a difference between temperatures existing before and after the heat exchange medium flows through the cold plate 300 is large, and a difference between temperatures existing before and after the heat exchange medium flows through the air-liquid heat exchanger 400 is small. In this application, the heat exchange medium is controlled to sequentially flow through the air-liquid heat exchanger 400 and the cold plate 300, so that heat dissipation for the heat-generating component in two heat dissipation manners can be considered, which is conducive to better heat dissipation for the various heat-generating components.

Usually, when a heat dissipation requirement of the power module 10 is high, the power module 10 may dissipate heat for the heat-generating component in a manner in which the cold plate 300 and the air-liquid heat exchanger 400 run in parallel. Running in parallel can quickly cool the various heat-generating components. When a heat dissipation requirement of the power module 10 is small, the power module 10 may dissipate heat for the heat-generating component in a manner in which the cold plate 300 and the air-liquid heat exchanger 400 run in series, to reduce energy consumption.

In an implementation, the connector 200 includes the connection base 210, the first cover 220, and the partition plate 240. The connection base 210 and the first cover 220 enclose to form the first cavity 251, and the partition plate 240 divides the first cavity 251 to form the first sub-cavity 201, the second sub-cavity 202, and the third sub-cavity 203. The connector 200 may include two connected partition plates 240, for example, a partition plate 240a and a partition plate 240b in FIG. 9. The partition plate 240a is located between the cold plate inlet 211 and the cold plate outlet 212, and between the heat exchanger outlet 214 and the heat exchanger inlet 213 (with reference to FIG. 8). The partition plate 240a is configured to separate the cold plate inlet 211 and the heat exchanger outlet 214 respectively from the cold plate outlet 212 and the heat exchanger inlet 213. The partition plate 240b is located between the cold plate outlet 212 and the heat exchanger inlet 213 and is configured to separate the cold plate outlet 212 from the heat exchanger inlet 213.

The connection base 210 includes the cold plate inlet 211, the cold plate outlet 212, the heat exchanger inlet 213, and the heat exchanger outlet 214. Along the third direction Z, the cold plate inlet 211 and the heat exchanger outlet 214 are adjacently arranged, and the cold plate outlet 212 and the heat exchanger inlet 213 are adjacently arranged (as shown in FIG. 8 and FIG. 9).

The first cover 220 includes the liquid inlet hole 221 and the liquid outlet hole 222. The liquid inlet hole 221 and the liquid outlet hole 222 each penetrate the first cover 220 along the first direction X. The liquid inlet hole 221 communicates with the first sub-cavity 201 to communicate with the heat exchanger inlet 213. The liquid outlet hole 222 communicates with the third sub-cavity 203 to communicate with the cold plate outlet 212. The liquid inlet hole 221 and the liquid outlet hole 222 are arranged along the third direction Z.

In an implementation, the connector 200 further includes the second cavity 252 and the liquid discharge hole 215 (as shown in FIG. 8 and FIG. 9). The second cavity 252 and the first sub-cavity 201, the second sub-cavity 202, and the third sub-cavity 203 are adjacently arranged and spaced apart along the first direction X. In an implementation, the connector 200 further includes the second cover 230. The second cover 230 and a side that is of the connection base 210 and that faces away from the first cover 220 along the first direction X enclose to form the second cavity 252. The liquid discharge hole 215 penetrates the connection base 210 along the first direction X. The second cavity 252 and the liquid discharge hole 215 are configured to increase sealing performance of the connector 200, and reduce a risk that the heat exchange medium leaks into the housing 100.

It should be noted that, for another structural feature that is of the connector 200 and that exists when the cold plate 300 and the air-liquid heat exchanger 400 run in series, refer to the foregoing structural feature that is of the connector 200 and that exists when the cold plate 300 and the air-liquid heat exchanger 400 run in parallel. Details are not described herein again.

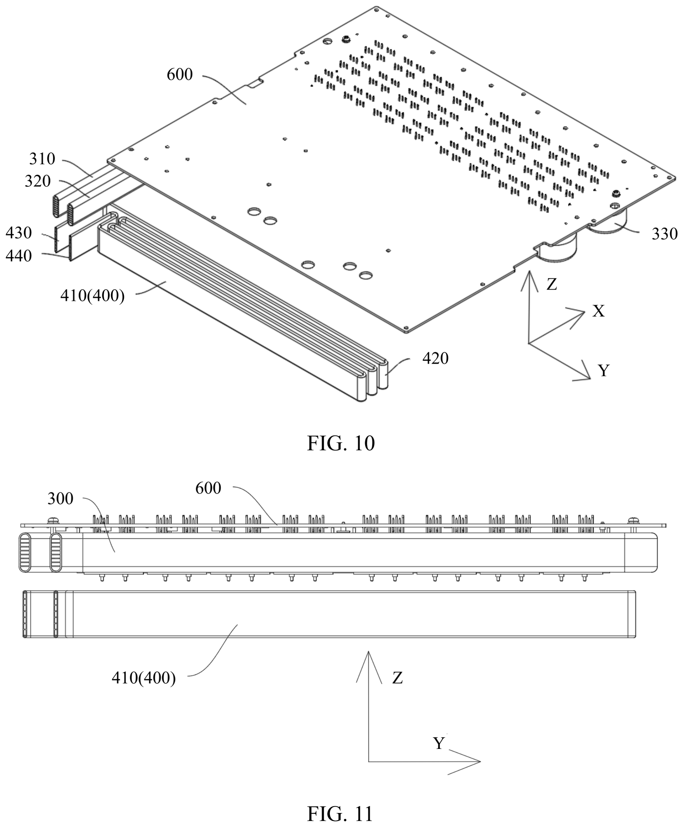

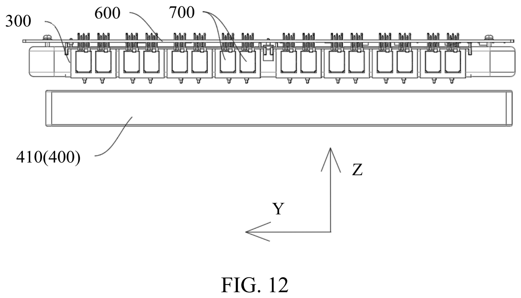

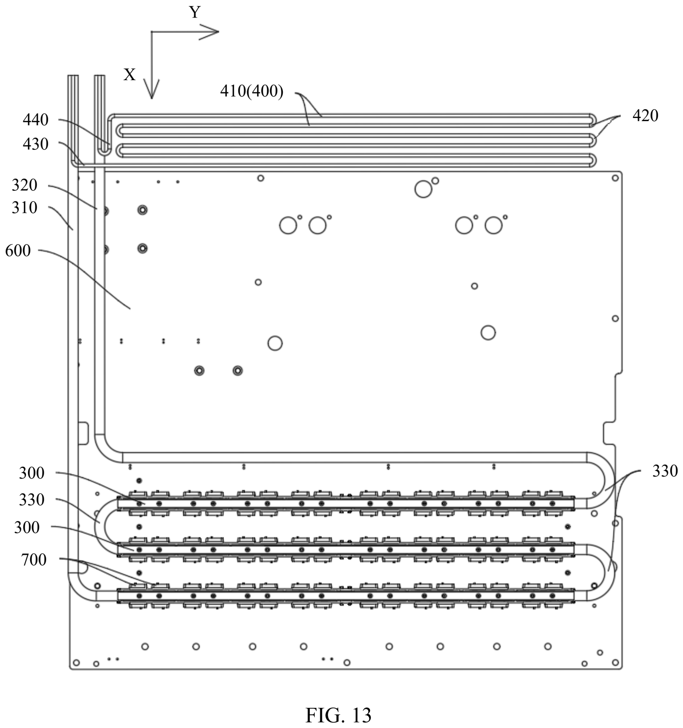

Refer to FIG. 10, FIG. 11, FIG. 12, and FIG. 13. FIG. 10 is a three-dimensional diagram of a circuit board 600, the cold plate 300, and the air-liquid heat exchanger 400 according to an implementation of this application. FIG. 11 is a front view of the circuit board 600, the cold plate 300, and the air-liquid heat exchanger 400 according to an implementation of this application. FIG. 12 is a rear view of the circuit board 600, the cold plate 300, and the air-liquid heat exchanger 400 according to an implementation of this application. FIG. 13 is a top view of the circuit board 600, the cold plate 300, and the air-liquid heat exchanger 400 according to an implementation of this application.

In a possible implementation, the power module 10 further includes the circuit board 600 and a plurality of power transistors 700. The housing 100 includes the top plate 150 and the bottom plate 160 (refer to FIG. 3 and FIG. 4). The top plate 150 and the bottom plate 160 are oppositely arranged along the third direction Z. The circuit board 600 is arranged between and spaced from the top plate 150 and the bottom plate 160. The plurality of power transistors 700 and the cold plate 300 are arranged on a side that is of the circuit board 600 and that faces the bottom plate 160. The cold plate 300 is in contact with at least one power transistor 700 along the first direction X.

The power transistor 700 may be an IGBT transistor, a MOSFET, or another type of power transistor 700. The plurality of power transistors 700 are connected to the circuit board 600 along the third direction Z. The power transistor 700 and the circuit board 600 are jointly configured to implement power change. The at least one power transistor 700 and the cold plate 300 are stacked along the first direction X (as shown in FIG. 12 and FIG. 13), and a side surface of the at least one power transistor 700 along the first direction X is in contact with the cold plate 300. Both side surfaces that are of the cold plate 300 and that are provided opposite to each other along the first direction X may be used to be in contact with the power transistor 700.

In an implementation, all the plurality of power transistors 700 are in contact with the cold plate 300 along the first direction X.

In the power module 10 provided in this application, the power transistor 700 is a high-heat-generating component, and the cold plate 300 is configured to dissipate heat for the power transistor 700, so that cooling efficiency of the power transistor 700 can be improved. The first direction X is a direction parallel to the circuit board 600, and the cold plate 300 is bonded to the power transistor 700 along the first direction X, so that a size of the power module 10 along the third direction X can be reduced.

In an implementation, a length of the cold plate 300 along the first direction X is less than a length of the cold plate 300 along the third direction Z. The two side surfaces that are of the cold plate 300 and that are provided opposite to each other along the first direction X are side surfaces with larger areas. The side surface of the cold plate 300 with the larger area is in contact with the power transistor 700, so that the power transistor 700 can be better cooled.

In an implementation, a length of the power transistor 700 along the first direction X is less than a length of the power transistor 700 along the second direction Y. Two side surfaces that are of the power transistor 700 and that are provided opposite to each other along the first direction X are side surfaces with larger areas. The side surface of the power transistor 700 with the larger area is in contact with the cold plate 300, so that a contact area between the power transistor 700 and the cold plate 300 is increased, and the power transistor 700 is quickly cooled.

In an implementation, along the first direction X, a projection of the cold plate 300 covers a projection of the power transistor 700. The contact area between the power transistor 700 and the cold plate 300 is large, which is conducive to quickly cooling the power transistor 700.

In an implementation, at least one of silicone grease and a ceramic piece is further included between the power transistor 700 and the cold plate 300. The power transistor 700 is bonded to the cold plate 300 by using the silicone grease and/or the ceramic piece. The silicone grease and the ceramic piece have good thermal conductivity and insulation performance, and can isolate the power transistor 700 from the cold plate 300 without affecting quick heat dissipation for the power transistor 700.

In a possible implementation, the power module 10 includes a plurality of connected cold plates 300. The plurality of cold plates 300 are spaced apart along the first direction X. The plurality of power transistors 700 include a plurality of columns of power transistors 700 that are spaced apart along the first direction X (as shown in FIG. 4 and FIG. 13). Each column of power transistors 700 includes a plurality of power transistors 700 that are sequentially arranged along the second direction Y. The plurality of power transistors 700 of each column of power transistors 700 are in contact with a same cold plate 300.

The cold plate 300 extends along the second direction Y. A length of the cold plate 300 along the second direction Y is greater than or equal to a length of each column of power transistors 700 along the second direction Y. Same sides that are of the plurality of power transistors 700 of each column of power transistors 700 and that are along the first direction X are in contact with a same side surface that is of the cold plate 300 and that is along the first direction X. In an implementation shown in FIG. 13, the power module 10 includes six columns of power transistors 700, and each column of power transistors 700 includes 16 power transistors.

In the power module 10 provided in this application, one cold plate 300 may be configured to cool at least one column of power transistors 700, which improves utilization of the cold plate 300. In addition, in this application, the plurality of cold plates 300 are disposed to cool the plurality of columns of power transistors 700, so that heat dissipation can be better performed on the plurality of columns of power transistors 700 in the power module 10, to improve reliability of the power module 10.

In an implementation, the power module 10 further includes at least one cold plate connection pipe 330 (as shown in FIG. 13). The at least one cold plate connection pipe 330 and the plurality of cold plates 300 are alternately arranged along the first direction X. The cold plate connection pipe 330 is configured to connect two adjacent cold plates 300. The cold plate connection pipe 330 may be configured to implement a series connection between the plurality of cold plates 300. In an implementation, the at least one cold plate connection pipe 330 and the plurality of cold plates 300 are of an integrated structure. This improves overall structural strength of the at least one cold plate connection pipe 330 and the plurality of cold plates 300, and also reduces welding joints between the cold plate connection pipe 330 and the cold plates 300, to reduce a risk of leakage of the heat exchange medium.

In an implementation, the power module 10 further includes the liquid inlet pipe 310 of the cold plate and the liquid outlet pipe 320 of the cold plate (as shown in FIG. 13). One end of the liquid inlet pipe 310 of the cold plate is used for the cold plate inlet 211 of the connector 200, and one end of the liquid inlet pipe 310 of the cold plate is used to communicate with an inlet of a first cold plate 300 of the plurality of cold plates 300. One end of the liquid outlet pipe 320 of the cold plate is used to communicate with the cold plate outlet 212 of the connector 200, and one end of the liquid outlet pipe 320 of the cold plate is used to communicate with an outlet of a last cold plate 300 of the plurality of cold plates 300. The first cold plate 300 and the last cold plate 300 are respectively a first cold plate 300 and a last cold plate 300 in the plurality of cold plates 300 along the first direction.

In an implementation, the liquid inlet pipe 310 of the cold plate, the plurality of cold plates 300, the at least one cold plate connection pipe 330, and the liquid outlet pipe 320 of the cold plate are of an integrated structure. This improves overall structural strength of the liquid inlet pipe 310 of the cold plate, the plurality of cold plates 300, the at least one cold plate connection pipe 330, and the liquid outlet pipe 320 of the cold plate, and also reduces the welding joints between the cold plate connection pipe 330 and the plurality of cold plates 300, welding joints between the liquid inlet pipe 310 of the cold plate and the cold plate 300, and welding joints between the liquid outlet pipe 320 of the cold plate and the cold plate 300, to reduce the risk of leakage of the heat exchange medium.

In an implementation, the liquid inlet pipe 310 of the cold plate, the plurality of cold plates 300, the at least one cold plate connection pipe 330, and the liquid outlet pipe 320 of the cold plate are connected to form a cooling pipe. The cooling pipe is formed by bending a flat pipe for a plurality of times. The cooling pipe is integrally formed, which reduces the risk of leakage of the heat exchange medium.

In a possible implementation, at least one cold plate 300 is arranged between two adjacent columns of power transistors 700 (as shown in FIG. 13). The at least one cold plate 300 includes two sides along the first direction X. One side of the at least one cold plate 300 is in contact with a plurality of power transistors 700 of one column of power transistors 700. The other side of the at least one cold plate 300 is in contact with a plurality of power transistors 700 of the other column of power transistors 700. Both sides of the cold plate 300 along the first direction X are used to cool the power transistors 700. One cold plate 300 may cool two columns of power transistors 700, which improves utilization of the cold plate 300.

In an implementation, along the first direction X, a spacing between two adjacent cold plates 300 is greater than twice a thickness of the power transistor 700. Along the first direction X, two columns of power transistors 700 are disposed between two adjacent cold plates 300, and the two columns of power transistors 700 are in contact with different cold plates 300.

In an implementation, along the first direction X, the spacing between two adjacent cold plates 300 is equal to the thickness of the power transistor 700. One column of power transistors 700 is disposed between two adjacent cold plates 300 along the first direction X. Two sides of the column of power transistors 700 along the first direction X are in contact with the two cold plates 300, which improves cooling efficiency of the power transistor 700.

In an implementation, along the third direction Z, projections of the plurality of cold plates 300 do not overlap a projection of the air-liquid heat exchanger 400 (as shown in FIG. 4 and FIG. 13). The cold plate 300 and the air-liquid heat exchanger 400 are disposed in a staggered manner along the first direction X, to avoid damage to the power transistor 700 caused by contact between the power transistor 700 and the air-liquid heat exchanger 400. Because the plurality of cold plates 300 and the air-liquid heat exchanger 400 are disposed in a staggered manner, a gap is reserved between the cold plate 300 and the bottom plate 160. In this case, a fastener may be disposed between the circuit board 600 and the bottom plate 160. The fastener is configured to clamp the power transistor 700 and the cold plate 300, to ensure heat dissipation effect of the power transistor 700. The fastener can further support the power transistor 700 and the cold plate 300.

In a possible implementation, along the third direction Z, a distance between the air-liquid heat exchanger 400 and the top plate 150 is greater than a distance between the cold plate 300 and the top plate 150 (with reference to FIG. 3, FIG. 4, and FIG. 11). A spacing between the top plate 150 and at least one of the cold plate inlet 211 or the cold plate outlet 212 is less than the spacing between the air-liquid heat exchanger 400 and the top plate 150, and a spacing between the bottom plate 160 and at least one of the heat exchanger inlet 213 or the heat exchanger outlet 214 is less than a spacing between the cold plate 300 and the bottom plate 160. The air-liquid heat exchanger 400 and the cold plate 300 are disposed in a staggered manner along the third direction Z, and the cold plate inlet 211, the cold plate outlet 212, the heat exchanger inlet 213, and the heat exchanger outlet 214 are disposed in a centralized manner, to facilitate reduction in the size of the connector 200.

In an implementation, along the third direction Z, a spacing between the cold plate inlet 211 and the heat exchanger inlet 213 or a spacing between the cold plate outlet 212 and the heat exchanger outlet 214 is less than or equal to a spacing between the air-liquid heat exchanger 400 and the cold plate 300, and a size of the connector 200 along the third direction Z is small, to facilitate miniaturization of the connector 200.

Refer to FIG. 4, FIG. 13, and FIG. 14. In a possible implementation, the air-liquid heat exchanger 400 includes a plurality of connected heat exchange plates 410. The air-liquid heat exchanger 400 is located between the connector 200 and the circuit board 600 along the first direction X, the air-liquid heat exchanger 400 is arranged between and spaced from the top plate 150 and the bottom plate 160 along the third direction Z, and the plurality of heat exchange plates 410 are spaced apart along the first direction X. Along the third direction Z, the projection of the air-liquid heat exchanger 400 does not overlap a projection of the circuit board 600. The air-liquid heat exchanger 400 and the circuit board 600 are disposed in a staggered manner, so that the air-liquid heat exchanger 400 does not interfere with carrying of the component on the circuit board 600, and space utilization of the circuit board 600 is high, which is conducive to improving performance of the power module 10.

Usually, to carry more onboard components, the circuit board 600 has a large volume. In addition, because the inductor 500 is located on a side that is of the circuit board 600 and that is close to the rear plate 120 along the first direction X, a distance between the air-liquid heat exchanger 400 and the front plate 110 is small, and usually, no component is placed between the air-liquid heat exchanger 400 and the front plate 110. In this case, the plurality of heat exchange plates 410 of the air-liquid heat exchanger 400 are spaced apart along the first direction X, and the air-liquid heat exchanger 400 performs ventilation along the third direction Z. The air in the housing 100 passes through a gap between two adjacent heat exchange plates 410 along the third direction Z, and performs heat exchange with the heat exchange plates 410, to cool the air in the housing 100. The plurality of heat exchange plates 410 are arranged along the first direction X, which is more conducive to heat dissipation for the power module 10.

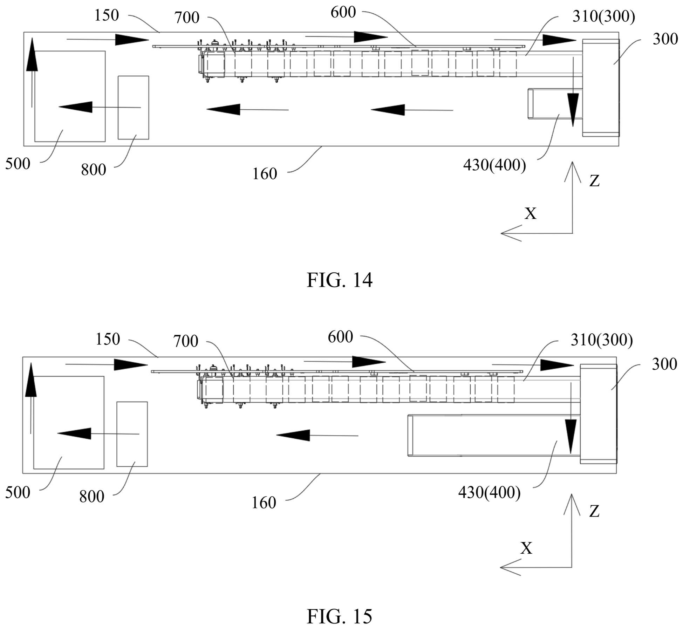

In an implementation, the power module 10 further includes a fan 800 (as shown in FIG. 14). The fan 800 is configured to drive the air in the housing 100 to flow to the air-liquid heat exchanger 400. The fan 800 is disposed to accelerate an air velocity in the housing 100, which is more conducive to quick heat dissipation for the heat-generating component in the housing 100.

In an implementation, as shown by arrows in FIG. 14, the fan 800 drives the air to pass through a gap between the circuit board 600 and the bottom plate 160 along the first direction X, to take away heat of the heat-generating component between the circuit board 600 and the bottom plate 160. Then, the air enters a gap between the circuit board 600 and the top plate 150 along the third direction Z through a gap between the circuit board 600 and the rear plate 120. The air flows through the gap between the circuit board 600 and the top plate 150 along the first direction X, to cool a side surface that is of the circuit board 600 and that faces the top plate 150. Then, the air flows to a gap between the circuit board 600 and the front plate 110 along the third direction Z, and passes through the air-liquid heat exchanger 400. The air performs heat exchange with the air-liquid heat exchanger 400, and then is converted into low-temperature air. The low-temperature air enters the gap between the circuit board 600 and the bottom plate 160. In this circulating manner, the various heat-generating components in the housing 100 are cooled. The air flows through parts below and above the circuit board 600, which is conducive to adequate heat dissipation for the circuit board and other heat-generating components.

In an implementation, a flow direction of the air in the housing 100 may alternatively be as follows: The air sequentially passes through the gap between the circuit board 600 and the bottom plate 160 and the gap between the circuit board 600 and the front plate 110, and passes through the air-liquid heat exchanger 400, the gap between the circuit board 600 and the top plate 150, and the gap between the circuit board 600 and the rear plate 120.

In an implementation, a length of the heat exchange plate 410 along the first direction X is less than a length of the heat exchange plate 410 along the third direction Z. The heat exchange plate 410 extends along the second direction. Two side surfaces that are of the heat exchange plate 410 and that are provided opposite to each other along the first direction X are side surfaces of the heat exchange plate 410 with larger areas. The plurality of heat exchange plates 410 are arranged along the first direction X. A volume of the air-liquid heat exchanger 400 including the plurality of heat exchange plates 410 is small, which is conducive to reducing the volume of the power module 10. In addition, after entering the air-liquid heat exchanger 400, the air is in contact with the surface of the heat exchange plate 410 with the larger area. A heat exchange area between the air and the heat exchange plate 410 is large, so that the air-liquid heat exchanger 400 quickly cools the air.

In an implementation, along the first direction X, a spacing between two adjacent heat exchange plates 410 is less than the spacing between two adjacent cold plates 300. The spacing between two adjacent heat exchange plates 410 is small, which is conducive to adding the heat exchange plate 410 to enhance heat dissipation effect of the air-liquid heat exchanger 400 or reduce the volume of the air-liquid heat exchanger 400.

In an implementation, along the first direction X, the length of the heat exchange plate 410 is less than the length of the cold plate 300. The heat exchange plate 410 is thinner along the first direction X, which is more conducive to improving heat exchange efficiency between the heat exchange plate 410 and the air.

In an implementation, along the third direction Z, the length of the heat exchange plate 410 is greater than the length of the cold plate 300. The length of the heat exchange plate 410 along the third direction Z is longer, which increases the heat exchange area between the air and the heat exchange plate 410, and is more conducive to quickly cooling the air by the air-liquid heat exchanger 400.

In an implementation, the power module 10 further includes at least one heat exchange plate connection pipe 420 (as shown in FIG. 13). The at least one heat exchange plate connection pipe 420 and the plurality of heat exchange plates 410 are alternately arranged along the first direction X. The heat exchange plate connection pipe 420 is configured to connect two adjacent heat exchange plates 410. The heat exchange plate connection pipe 420 may be configured to implement a series connection between the plurality of heat exchange plates 410. In an implementation, the at least one heat exchange plate connection pipe 420 and the plurality of heat exchange plates 410 are of an integrated structure. This improves overall structural strength of the at least one heat exchange plate connection pipe 420 and the plurality of heat exchange plates 410, and also reduces welding joints between the heat exchange plate connection pipe 420 and the heat exchange plates 410, to reduce the risk of leakage of the heat exchange medium.

In an implementation, the power module 10 further includes the liquid inlet pipe 430 of the heat exchanger and the liquid outlet pipe 440 of the heat exchanger (as shown in FIG. 13). One end of the liquid inlet pipe 430 of the heat exchanger is used for the heat exchanger inlet 213 of the connector 200, and one end of the liquid inlet pipe 430 of the heat exchanger is used to communicate with an inlet of a first heat exchange plate 410 of the plurality of heat exchange plates 410. One end of the liquid outlet pipe 440 of the heat exchanger is used to communicate with the heat exchanger outlet 214 of the connector 200, and one end of the liquid outlet pipe 440 of the heat exchanger is used to communicate with an outlet of a last heat exchange plate 410 of the plurality of heat exchange plates 410. The first heat exchange plate 410 and the last heat exchange plate 410 are respectively a first heat exchange plate 410 and a last heat exchange plate 410 in the plurality of heat exchange plates 410 along the first direction.

In an implementation, the liquid inlet pipe 430 of the heat exchanger, the plurality of heat exchange plates 410, the at least one heat exchange plate connection pipe 420, and the liquid outlet pipe 440 of the heat exchanger are of an integrated structure. This improves overall structural strength of the liquid inlet pipe 430 of the heat exchanger, the plurality of heat exchange plates 410, the at least one heat exchange plate connection pipe 420, and the liquid outlet pipe 440 of the heat exchanger, and also reduces the welding joints between the heat exchange plate connection pipe 420 and the plurality of heat exchange plates 410, welding joints between the liquid inlet pipe 430 of the heat exchanger and the heat exchange plate 410, and welding joints between the liquid outlet pipe 440 of the heat exchanger and the heat exchange plate 410, to reduce the risk of leakage of the heat exchange medium.

In an implementation, the liquid inlet pipe 430 of the heat exchanger, the plurality of heat exchange plates 410, the at least one heat exchange plate connection pipe 420, and the liquid outlet pipe 440 of the heat exchanger are connected to form a heat exchange pipe. The heat exchange pipe is formed by bending a flat pipe for a plurality of times. The cooling pipe is integrally formed, which reduces the risk of leakage of the heat exchange medium.

In an implementation, both the heat exchange pipe and the cooling pipe are of an integrated structure. The heat exchange pipe and the cooling pipe are both welded to the connector 200. Except welding joints that exist on welding parts between the heat exchange pipe and the cooling pipe and the connector 200, no welding seam exists in the heat exchange pipe and the cooling pipe, which reduces the risk of leakage of the heat exchange medium. In addition, a design in which the heat exchange pipe and the cooling pipe each are welded together the connector 200 makes structures of the heat exchange pipe and the cooling pipe more compact, which improves reliability of the power module 10.

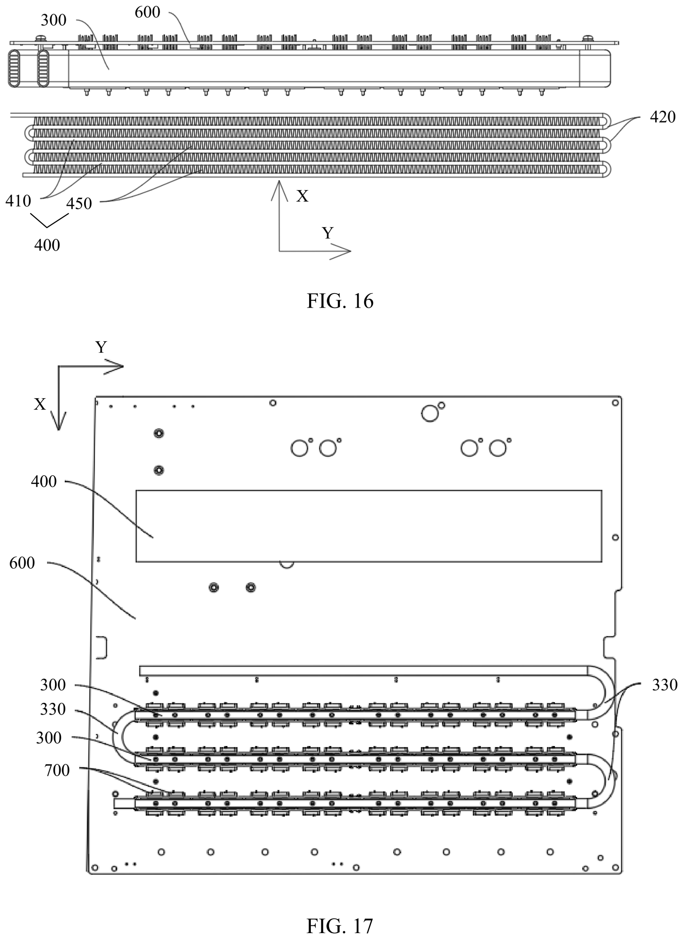

Refer to FIG. 15, FIG. 16, and FIG. 17. FIG. 15 is a diagram of the power module 10 according to an implementation of this application. FIG. 16 is a front view of the circuit board 600, the cold plate 300, and the air-liquid heat exchanger 400 according to an implementation of this application. FIG. 17 is a top view of the circuit board 600, the cold plate 300, and the air-liquid heat exchanger 400 according to an implementation of this application.

In a possible implementation, the projection of the air-liquid heat exchanger 400 along the third direction Z overlaps the projection of the circuit board 600 along the third direction Z, the projection of the air-liquid heat exchanger 400 along the third direction Z is staggered with a projection of the cold plate 300 along the third direction Z, and the plurality of heat exchange plates 410 are spaced apart along the third direction Z. The air-liquid heat exchanger 400 and the circuit board 600 are disposed in an overlapping manner along the third direction Z, and both front and rear sides of the air-liquid heat exchanger 400 along the first direction X are disposed with the onboard components. In this case, the plurality of heat exchange plates 410 are arranged along the third direction Z, and the air-liquid heat exchanger 400 performs ventilation along the first direction X, so that heat dissipation for both the front and rear onboard components on the circuit board 600 along the first direction X can be considered.

Refer to FIG. 15. In an implementation, the flow direction of the air in the housing 100 may be as follows: The air passes through the gap between the circuit board 600 and the bottom plate 160 and passes through the air-liquid heat exchanger 400 along the first direction X, so that the air flows to take away heat of the heat-generating component between the circuit board 600 and the bottom plate 160. After passing through the air-liquid heat exchanger 400, the air is converted into low-temperature air. Then, air enters the gap between the circuit board 600 and the top plate 150 along the third direction Z through the gap between the circuit board 600 and the rear plate 120. The air flows through the gap between the circuit board 600 and the top plate 150 along the first direction X, to cool the side surface that is of the circuit board 600 and that faces the top plate 150. Then, the air flows through the gap between the circuit board 600 and the front plate 110 along the third direction Z, and flows through the gap between the circuit board 600 and the bottom plate 160 along the first direction X. In this circulating manner, the various heat-generating components in the housing 100 are cooled. The air flows through the parts below and above the circuit board 600, which is conducive to adequate heat dissipation for the circuit board and other heat-generating components. In an implementation, the flow direction of the air may alternatively be opposite to the foregoing flow direction.

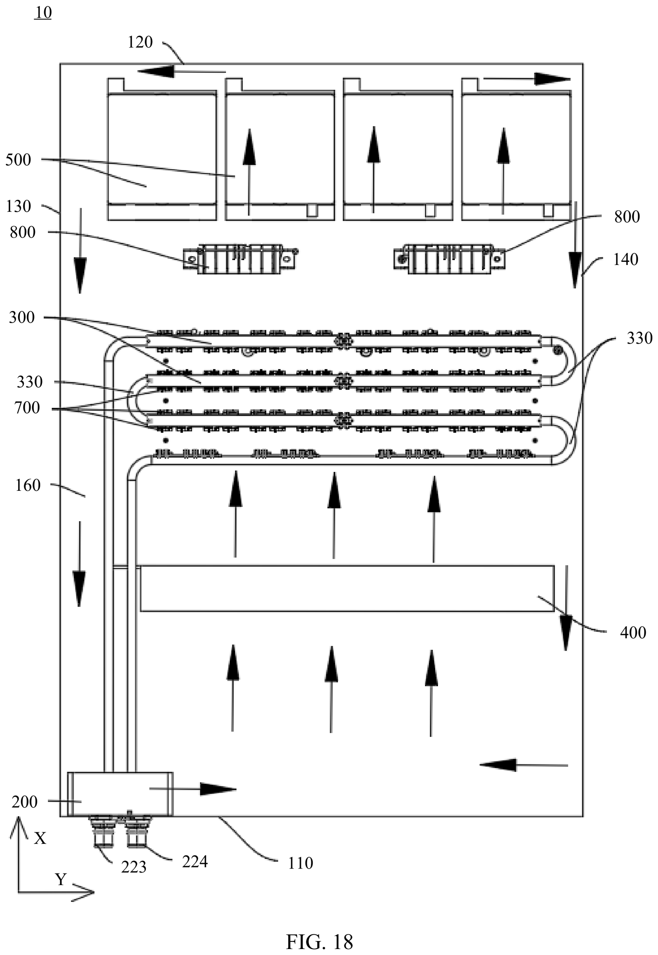

Refer to FIG. 18. In an implementation, the flow direction of the air in the housing 100 may alternatively be as follows: The air flows from the front plate 110 to the rear plate 120 along the first direction X, and flows through the air-liquid heat exchanger 400. The air changes the flow direction at the rear plate 120, and flows from the rear plate 120 to the front plate 110 along the first direction X. In this circulating manner, the components in the housing 100 are cooled. The air may first flow through a region between the circuit board 600 and the top plate 150 and a region between the circuit board 600 and the bottom plate 160, and then return in an opposite direction from a gap between the circuit board 600 and the first side plate 130 and a gap between the circuit board 600 and the second side plate 140. In an implementation, the flow direction of the air may alternatively be opposite to the foregoing flow direction.

It should be noted that the foregoing two different air flow manners may be used in combination.

In an implementation, the air-liquid heat exchanger 400 further includes a fin 450 (as shown in FIG. 16). The fin 450 is located between two adjacent heat exchange plates 410. The fin 450 has good thermal conductivity. The air in the housing 100 transfers heat to the heat exchange medium in the heat exchange plate 410 by using the fin 450. The fin 450 is disposed to improve a heat exchange rate between the air-liquid heat exchanger 400 and the air in the housing 100.

In an implementation, a plurality of microchannels are disposed in both the cold plate 300 and the heat exchange plate 410. The microchannels can improve heat exchange efficiency of the cold plate 300 and the heat exchange plate 410.

In a possible implementation, the power module 10 includes a plurality of inductors 500 and a plurality of fans 800 (as shown in FIG. 4 and FIG. 18). The plurality of inductors 500 are spaced apart along the second direction Y. The plurality of fans 800 are spaced apart along the second direction Y. The fan 800 is located between the inductor 500 and the circuit board 600 along the first direction X. The fan 800 plays a role in disturbing flow, and the fan 800 may provide power for the air to flow to the air-liquid heat exchanger 400, to improve heat dissipation effect of the air-liquid heat exchanger 400. The fan 800 is located between the inductor 500 and the circuit board 600, which does not interfere with installation of the various components, and can also achieve good heat dissipation effect.

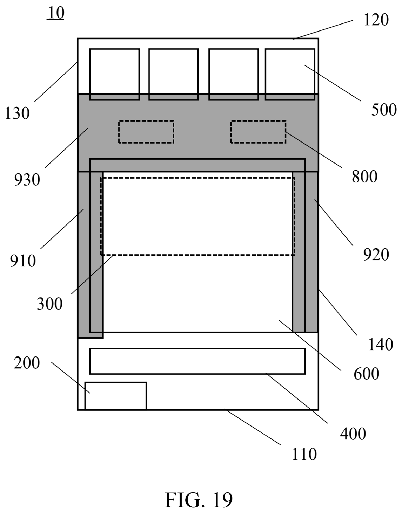

Refer to FIG. 19. In a possible implementation, the power module 10 further includes a first baffle plate 910, a second baffle plate 920, and a third baffle plate 930. The first baffle plate 910 and the second baffle plate 920 are located on two sides that are of the circuit board 600 and that are along the second direction Y. The third baffle plate 930 is located between the top plate 150 and the fan 800 along the third direction Z. Two sides of the first baffle plate 910 and along the second direction Y are connected to the circuit board 600 and the first side plate 110. Two sides of the second baffle plate 920 along the second direction Y are connected to the circuit board 600 and the second side plate 120. When two sides of the third baffle plate along the first direction are connected to the circuit board and the inductor, the air-liquid heat exchanger 400 is located between the connector 200 and the circuit board 600 along the first direction X or the projection of the air-liquid heat exchanger 400 along the third direction Z overlaps the projection of the circuit board 600 along the third direction Z.

The first baffle plate 910, the second baffle plate 920, and the third baffle plate 930 are disposed to guide the air to circulate through the parts below and above the circuit board 600. For example, the first baffle plate 910, the second baffle plate 920, and the third baffle plate 930 may guide the air to sequentially flow along the gap between the circuit board 600 and the bottom plate 160, the gap between the circuit board 600 and the rear plate 120, the gap between the circuit board 600 and the top plate 150, and the gap between the circuit board 600 and the front plate 110 (with reference to FIG. 19, FIG. 4, and FIG. 14).

The third baffle plate 930 is configured to cover a gap between the inductor 500 and the circuit board 600, to prevent a case in which the air is blocked by the inductor 500 when flowing along the first direction X in the gap between the circuit board 600 and the bottom plate 160 and then diverts to flow along the third direction Z to the top plate 150 without passing through the inductor 500, which causes poor heat dissipation effect of the inductor 500. After the third baffle plate 930 is disposed, the third baffle plate 930 blocks the air from flowing from the gap between the inductor 500 and the circuit board 600 to the top plate 150. In this case, the air first passes through the inductor 500 along the first direction X and flows to the rear plate 120, and then flows to the top plate 150 along the third direction Z, which is conducive to improving heat dissipation effect of the inductor 500.

The first baffle plate 910 and the second baffle plate 920 are respectively configured to cover the gap between the circuit board 600 and the first side plate 130 and the gap between the circuit board 600 and the second side plate 140, to prevent a case in which the air flowing in the gap between the circuit board 600 and the top plate 150 along the first direction X directly flows to the gap between the circuit board 600 and the bottom plate 160 through the gap between the circuit board 600 and the first side plate 130 and the gap between the circuit board 600 and the second side plate 140, and the air does not pass through the circuit board 600 and move close to a front end of the front plate 110 along the first direction X, which causes poor heat dissipation effect of a heat-generating component at the front end. In this application, the first baffle plate 910 and the second baffle plate 920 are disposed, and the air flowing in the part above the circuit board 600 needs to flow to the part below the circuit board 600 through a gap between the circuit board 600 and the front plate 110. The air flows within a range inside the entire housing 100, which is more conducive to implementing heat dissipation for the various heat-generating components by the air-liquid heat exchanger 400.

A flow mode in which the air circulates through the parts below and above the circuit board 600 may be applicable to two different placement positions of the air-liquid heat exchanger 400. To be specific, when the air-liquid heat exchanger 400 is located between the connector 200 and the circuit board 600 along the first direction X or the projection of the air-liquid heat exchanger 400 overlaps the projection of the circuit board 600 along the third direction Z, heat dissipation may be performed in the manner in which the air circulates through the parts below and above the circuit board 600. When the air-liquid heat exchanger 400 is located between the connector 200 and the circuit board 600 along the first direction X, the plurality of heat exchange plates 410 are spaced apart along the first direction X. When the projection of the air-liquid heat exchanger 400 overlaps the projection of the circuit board 600 along the third direction Z, the plurality of heat exchange plates 410 are spaced apart along the third direction Z.

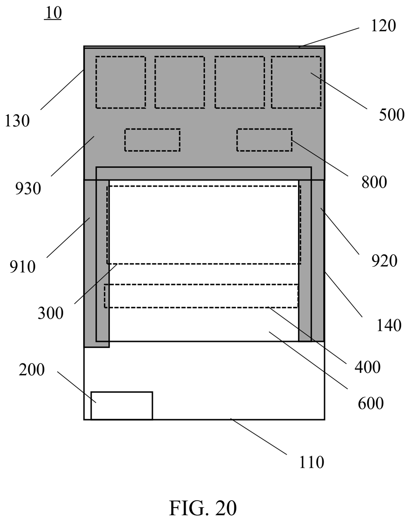

Refer to FIG. 20. In a possible implementation, when two sides of the third baffle plate 930 along the first direction X are connected to the circuit board 600 and the rear plate 120, the projection of the air-liquid heat exchanger 400 along the third direction Z overlaps the projection of the circuit board 600 along the third direction Z.

When the projection of the air-liquid heat exchanger 400 along the third direction Z overlaps the projection of the circuit board 600 along the third direction Z, the air in the housing 100 may further use a flow mode in which the air circulates through the circuit board 600 and the two sides of the circuit board 600 (with reference to FIG. 20 and FIG. 18). To be specific, the first baffle plate 910, the second baffle plate 920, and the third baffle plate 930 are disposed to guide the air to flow from the front plate 110 to the rear plate 120 along the first direction X in the gap between the circuit board 600 and the bottom plate 160, and then flow from the rear plate 120 to the front plate 110 in the gap between the circuit board 600 and the first side plate 130 and the gap between the circuit board 600 and the second side plate 140 along the first direction X.

The third baffle plate 930 is configured to cover a gap between the rear plate 120 and the circuit board 600, to prevent a case in which the air flows directly to the top plate 150 and enters the gap between the circuit board 600 and the top plate 150 when flowing in the gap between the circuit board 600 and the bottom plate 160 along the first direction X, which causes poor heat dissipation effect of the inductor 500 and a component below the circuit board 600. After the third baffle plate 930 is disposed, the third baffle plate 930 restricts the air to flowing in the part below the circuit board 600. In this case, the air first passes through the inductor 500 and flows to the rear plate 120 along the first direction X, and then flows to the first side plate 130 and the second side plate 140, which is conducive to improving heat dissipation effect of the inductor 500 and ensuring heat dissipation effect of other heat-generating components.

The first baffle plate 910 and the second baffle plate 920 are respectively configured to cover the gap between the circuit board 600 and the first side plate 130 and the gap between the circuit board 600 and the second side plate 140, to prevent a case in which the air flowing in the gap between the circuit board 600 and the bottom plate 160 along the first direction X directly flows to the gap between the circuit board 600 and the top plate 150 through the gap between the circuit board 600 and the first side plate 130 and the gap between the circuit board 600 and the second side plate 140, and an air circulation path is short, which causes poor heat dissipation effect of the heat-generating component. In this application, the first baffle plate 910 and the second baffle plate 920 are disposed, and the air flows in the part below the circuit board 600, and circulates through the circuit board 600 and the two sides that are of the circuit board 600 and that are along the second direction Y, which is conducive to implementing heat dissipation for the various heat-generating components by the air-liquid heat exchanger 400. In this heat dissipation mode, the air mainly flows along the first direction X. In this case, a ventilation direction of the air-liquid heat exchanger 400 is set to the first direction X, that is, the plurality of heat exchange plates 410 are spaced apart along the third direction Z, which is conducive to achieving good heat dissipation effect by the air-liquid heat exchanger 400.

Refer to FIG. 1. This application further provides an energy storage system. The energy storage system includes the energy storage cabinet 1, the battery pack 11, and the foregoing power module 10. The battery pack 11 is connected to the power module 10 and supplies power to the load 2 by using the power module 10. The energy storage cabinet 1 further includes the cabinet body 12, the cabinet door 13, and the cooling assembly 14. The cabinet door 13 is configured to close the cabinet body 12. The power module 10 and the battery pack 11 are stacked inside the cabinet body 12. The front plate 110 of the housing 100 of the power module 10 faces the cabinet door 13. The cooling assembly 14 is connected to the cold plate inlet 211, the heat exchanger inlet 213, the cold plate outlet 212, and the heat exchanger outlet 214 of the connector 200 through the two liquid cooling pipes 15.

The power module and the energy storage system provided in embodiments of this application are described above in detail. The principle and embodiments of this application are described in this specification through specific examples. The descriptions about embodiments of this application are merely provided to help understand the method and core ideas of this application. In addition, persons of ordinary skill in the art can make variations and modifications to this application in terms of the specific embodiments and application scopes according to the ideas of this application. Therefore, the content of this specification shall not be construed as a limit to this application.

## Claims

1. A power module, wherein the power module comprises a housing, a connector, an inductor, a cold plate, and an air-liquid heat exchanger; the connector, the air-liquid heat exchanger, the cold plate, and the inductor are sequentially arranged inside the housing along a first direction; the housing comprises a front plate and a rear plate, and the front plate and the rear plate are oppositely arranged along the first direction; and the connector is arranged between the air-liquid heat exchanger and the front plate along the first direction, and the connector comprises a cold plate inlet, a heat exchanger inlet, a cold plate outlet, and a heat exchanger outlet, wherein
along a second direction, the cold plate inlet and the cold plate outlet are adjacently arranged, and the heat exchanger inlet and the heat exchanger outlet are adjacently arranged, wherein the second direction is perpendicular to the first direction; and
along a third direction, the heat exchanger inlet and one of the cold plate inlet and the cold plate outlet are adjacently arranged, and the heat exchanger outlet and the other one of the cold plate inlet and the cold plate outlet are adjacently arranged, wherein the third direction is perpendicular to the second direction and the first direction.

2. The power module according to claim 1, wherein the housing comprises a first side plate and a second side plate, the first side plate and the second side plate are oppositely arranged along the second direction, and the connector, the air-liquid heat exchanger, the cold plate, and the inductor are arranged between the first side plate and the second side plate, wherein
along the second direction, a distance between the connector and the first side plate is less than a distance between the connector and the second side plate, the distance between the connector and the first side plate is less than a distance between the air-liquid heat exchanger and the first side plate, the distance between the connector and the second side plate is greater than a distance between the air-liquid heat exchanger and the second side plate, and at least one of a spacing between the cold plate inlet and the cold plate outlet or a spacing between the heat exchanger inlet and the heat exchanger outlet is less than the spacing between the air-liquid heat exchanger and the first side plate.

3. The power module according to claim 1, wherein the connector comprises a first sub-cavity and a second sub-cavity, the first sub-cavity and the second sub-cavity are adjacently arranged and spaced apart along the second direction, the first sub-cavity is configured to communicate with the cold plate inlet and the heat exchanger inlet, and the second sub-cavity is configured to communicate with the cold plate outlet and the heat exchanger outlet.

4. The power module according to claim 1, wherein the connector comprises a first sub-cavity, a second sub-cavity, and a third sub-cavity, the first sub-cavity and the third sub-cavity are adjacently arranged and spaced apart along the third direction, the first sub-cavity or the third sub-cavity and the second sub-cavity are adjacently arranged and spaced apart along the second direction, the first sub-cavity is configured to communicate with the heat exchanger inlet, the second sub-cavity is configured to communicate with the heat exchanger outlet and the cold plate inlet, and the third sub-cavity is configured to communicate with the cold plate outlet.

5. The power module according to claim 3, wherein the connector further comprises a second cavity and a liquid discharge hole, the second cavity and the first sub-cavity or the second sub-cavity are adjacently arranged and spaced apart along the first direction, and the liquid discharge hole communicates with the second cavity.

6. The power module according to claim 5, wherein the connector comprises a first cover, a connection base, a second cover, and a partition plate; the first cover and the second cover are arranged on two sides of the connection base along the first direction, and respectively enclose with the two sides of the connection base to form a first cavity and the second cavity; the partition plate is located in the first cavity and is configured to divide the first cavity to form the first sub-cavity and the second sub-cavity; and the connection base comprises the cold plate inlet, the cold plate outlet, the heat exchanger inlet, and the heat exchanger outlet, and the cold plate inlet, the cold plate outlet, the heat exchanger inlet, and the heat exchanger outlet penetrate the connection base along the first direction, wherein
the first cover comprises a liquid inlet hole and a liquid outlet hole, the liquid inlet hole and the liquid outlet hole each penetrate the first cover along the first direction, the liquid inlet hole is configured to communicate with at least one of the cold plate inlet or the heat exchanger inlet, and the liquid outlet hole is configured to communicate with at least one of the cold plate outlet or the heat exchanger outlet; and
the second cover comprises a first opening, a second opening, a third opening, and a fourth opening, the first opening, the second opening, the third opening, and the fourth opening each penetrate the second cover along the first direction, and the first opening, the second opening, the third opening, and the fourth opening are respectively arranged opposite to the cold plate inlet, the cold plate outlet, the heat exchanger inlet, and the heat exchanger outlet along the first direction.

7. The power module according to claim 6, wherein the power module comprises a liquid inlet joint and a liquid outlet joint, the liquid inlet joint and the liquid outlet joint are fastened to the first cover and are respectively connected to the liquid inlet hole and the liquid outlet hole, the front plate comprises a through hole, and the through hole penetrates the front plate along the first direction, wherein
along the first direction, a projection of the through hole covers a projection of the liquid inlet joint and a projection of the liquid outlet joint, and a projection of the first cover covers the projection of the through hole; and
along the third direction, lengths of the liquid inlet joint and the liquid outlet joint are greater than a distance between the first cover and the front plate.

8. The power module according to claim 1, wherein the power module further comprises a circuit board and a plurality of power transistors, the housing comprises a top plate and a bottom plate, the top plate and the bottom plate are oppositely arranged along the third direction, the circuit board is arranged between and spaced from the top plate and the bottom plate, the plurality of power transistors and the cold plate are arranged on a side that is of the circuit board and that faces the bottom plate, and the cold plate is in contact with at least one power transistor along the first direction.

9. The power module according to claim 8, wherein the power module comprises a plurality of connected cold plates, the plurality of cold plates are spaced apart along the first direction, the plurality of power transistors comprise a plurality of columns of power transistors that are spaced apart along the first direction, each column of power transistors comprises a plurality of power transistors sequentially arranged along the second direction, and the plurality of power transistors of each column of power transistors are in contact with a same cold plate.

10. The power module according to claim 9, wherein at least one cold plate is arranged between two adjacent columns of power transistors, the at least one cold plate comprises two sides along the first direction, one side of the at least one cold plate is in contact with a plurality of power transistors of one column of power transistors, and the other side of the at least one cold plate is in contact with a plurality of power transistors of the other column of power transistors.

11. The power module according to claim 8, wherein along the third direction, a distance between the air-liquid heat exchanger and the top plate is greater than a distance between the cold plate and the top plate, a spacing between the top plate and at least one of the cold plate inlet or the cold plate outlet is less than the spacing between the air-liquid heat exchanger and the top plate, and a spacing between the bottom plate and at least one of the heat exchanger inlet or the heat exchanger outlet is less than a spacing between the cold plate and the bottom plate.

12. The power module according to claim 8, wherein the air-liquid heat exchanger comprises a plurality of connected heat exchange plates; and when the air-liquid heat exchanger is located between the connector and the circuit board along the first direction, and the air-liquid heat exchanger is arranged between and spaced from the top plate and the bottom plate along the third direction, the plurality of heat exchange plates are spaced apart along the first direction; or when a projection of the air-liquid heat exchanger along the third direction overlaps a projection of the circuit board along the third direction, and the projection of the air-liquid heat exchanger along the third direction is staggered with a projection of the cold plate along the third direction, the plurality of heat exchange plates are spaced apart along the third direction.

13. The power module according to claim 8, wherein the power module comprises a plurality of inductors and a plurality of fans, the plurality of inductors are spaced apart along the second direction, the plurality of fans are spaced apart along the second direction, and the fan is located between the inductor and the circuit board along the first direction.

14. The power module according to claim 13, wherein the power module further comprises a first baffle plate, a second baffle plate, and a third baffle plate, the first baffle plate and the second baffle plate are located on two sides that are of the circuit board and that are along the second direction, and the third baffle plate is located between the top plate and the fan along the third direction; two sides of the first baffle plate along the second direction are connected to the circuit board and the first side plate, and two sides of the second baffle plate along the second direction are connected to the circuit board and the second side plate; and when two sides of the third baffle plate along the first direction are connected to the circuit board and the inductor, the air-liquid heat exchanger is located between the connector and the circuit board along the first direction or a projection of the air-liquid heat exchanger along the third direction overlaps a projection of the circuit board along the third direction; or when two sides of the third baffle plate along the first direction are connected to the circuit board and the rear plate, a projection of the air-liquid heat exchanger along the third direction overlaps a projection of the circuit board along the third direction.

15. An energy storage system, wherein the energy storage system comprises an energy storage cabinet, a battery pack, and the power module according to any one of claims 1 to 14, the battery pack is connected to the power module and supplies power to a load by using the power module, the energy storage cabinet comprises a cabinet body, a cabinet door, and a cooling assembly, the cabinet door is configured to close the cabinet body, the power module and the battery pack are stacked inside the cabinet body, and the cooling assembly is connected to the cold plate inlet, the heat exchanger inlet, the cold plate outlet, and the heat exchanger outlet of the connector through two liquid cooling pipes.
